# EUROPEAN PATENT APPLICATION

(11) **EP 4 661 620 A1**
(43) Date of publication of application: **10.12.2025**
(21) Application number: 25156081.9
(22) Date of filing: 05.02.2025
(51) Int. Cl.: H10D 84/01, H10D 30/01, H10D 30/00, H10D 30/67, H10D 64/23, H10D 84/83, H10D 88/00

(54) **SEMICONDUCTOR DEVICE**

(30) Priority: 03.06.2024 KR 20240072587
(71) Applicant: Samsung Electronics Co., Ltd., Suwon-si, Gyeonggi-do 16677 (KR)
(72) Inventor: MOON, Byungho, 16677 Suwon-si (KR); HWANG, Donghoon, 16677 Suwon-si (KR); JEON, Jaeho, 16677 Suwon-si (KR)
(74) Representative: Marks & Clerk LLP

(57) **Abstract**

Provided is a semiconductor device including a first active pattern and a second active pattern spaced apart from each other in a first direction, a first semiconductor pattern and a second semiconductor pattern overlapping the first active pattern, a third semiconductor pattern and a fourth semiconductor pattern overlapping the second active pattern, a lower isolation insulating layer between the first and second active patterns, source/drain patterns on the first and second active patterns and a gate electrode extending in the first direction. The first and third semiconductor patterns are arranged in the first direction. The second and fourth semiconductor patterns are arranged in the first direction. A width of the first semiconductor pattern in the first direction is greater than a width of the second semiconductor pattern in the first direction. A width of the third semiconductor pattern in the first direction is greater than a width of the fourth semiconductor pattern in the first direction.

## Description

### BACKGROUND

The present disclosure herein relates to a semiconductor device, and more particularly, to a semiconductor device including a gate electrode.

A semiconductor device can include an integrated circuit composed of metal-oxide-semiconductor field effect transistors (MOSFET). As a size and a design rule of semiconductor devices are gradually decreasing, scaling down of metal-oxide-semiconductor field effect transistors is also gradually being accelerated. As metal-oxide-semiconductor field effect transistors are gradually scaled down, operation characteristics of the semiconductor devices may be deteriorated. Accordingly, research on various methods for overcoming limitation caused by highintegration of semiconductor devices and forming semiconductor devices with more excellent performance is being conducted.

### SUMMARY

The present disclosure provides a semiconductor device with improved electrical characteristics and reliability.

An embodiment of the inventive concept provides a semiconductor device including a first active pattern and a second active pattern spaced apart from each other in a first direction, a first semiconductor pattern and a second semiconductor pattern overlapping the first active pattern, a third semiconductor pattern and a fourth semiconductor pattern overlapping the second active pattern, a lower isolation insulating layer between the first and second active patterns, source/drain patterns on the first and second active patterns, and a gate electrode extending in the first direction, wherein the first and third semiconductor patterns are arranged in the first direction, the second and fourth semiconductor patterns are arranged in the first direction, a width of the first semiconductor pattern in the first direction is greater than a width of the second semiconductor pattern in the first direction, a width of the third semiconductor pattern in the first direction is greater than a width of the fourth semiconductor pattern in the first direction, and a sidewall of the first semiconductor pattern and a sidewall of the third semiconductor pattern are in contact with the lower isolation insulating layer.

In an embodiment of the inventive concept, a semiconductor device includes a first active pattern and a second active pattern spaced apart from each other in a first direction, a first source/drain pattern and a second source/drain pattern on the first active pattern, a third source/drain pattern and a fourth source/drain pattern on the second active pattern, a lower isolation insulating layer between the first and second active patterns, and a gate electrode extending in the first direction, wherein the first and third source/drain patterns are arranged in the first direction, the second and fourth source/drain patterns are arranged in the first direction, a maximum width of the first source/drain pattern in the first direction is greater than a maximum width of the second source/drain pattern in the first direction, a maximum width of the third source/drain pattern in the first direction is greater than a maximum width of the fourth source/drain pattern in the first direction, and a first sidewall of the first source/drain pattern and a first sidewall of the third source/drain pattern are in contact with the lower isolation insulating layer.

In an embodiment of the inventive concept, a semiconductor device includes a first active pattern and a second active pattern spaced apart from each other in a first direction, a first source/drain pattern and a second source/drain pattern on the first active pattern, a third source/drain pattern and a fourth source/drain pattern on the second active pattern, a first semiconductor pattern in contact with the first source/drain pattern, a second semiconductor pattern in contact with the second source/drain pattern, a third semiconductor pattern in contact with the third source/drain pattern, a fourth semiconductor pattern in contact with the fourth source/drain pattern, a lower isolation insulating layer between the first and second active patterns, between the first and third source/drain patterns, and between the first and third semiconductor patterns, a first upper isolation insulating layer between the first and third source/drain patterns, a second upper isolation insulating layer between the second and fourth source/drain patterns, and a gate electrode extending in the first direction, wherein a width of the first source/drain pattern in the first direction is greater than a width of the second source/drain pattern in the first direction, and a width of the first semiconductor pattern in the first direction is greater than a width of the second semiconductor pattern in the first direction.

At least some of the above and other features of the invention are set out in the claims.

### BRIEF DESCRIPTION OF THE FIGURES

The accompanying drawings are included to provide a further understanding of the inventive concept, and are incorporated in and constitute a part of this specification. The drawings illustrate embodiments of the inventive concept and, together with the description, serve to explain principles of the inventive concept. In the drawings:
FIG. 1A is a plan view of a semiconductor device according to some embodiments;
FIG. 1B is a cross-sectional view taken along line A-A' of FIG. 1A;
FIG. 1C is a cross-sectional view taken along line B-B' of FIG. 1A;
FIG. 1D is a cross-sectional view taken along line C-C' of FIG. 1A;
FIG. 1E is a cross-sectional view taken along line D-D' of FIG. 1A;
FIG. 1F is a cross-sectional view taken along line E-E' of FIG. 1A;
FIG. 1G is a cross-sectional view taken along line C-C' of FIG. 1A;
FIG. 1H is a cross-sectional view taken along line G-G' of FIG. 1A;
FIG. 1I is a cross-sectional view taken along line H-H' of FIG. 1A;
FIGS. 2A, 2B, 2C, 2D, 2E, 3A, 3B, 3C, 4A, 4B, 4C, 4D, 4E, 5A, 5B, 5C, 5D, 5E, 5F, 5G, 5H, 5I, 6A, 6B, 6C, 6D, 6E, 7A, 7B, 7C, 7D, 7E, 7F, 7G and 7H are diagrams for describing a method for manufacturing a semiconductor device according to some embodiments;
FIG. 8 is a cross-sectional view of a semiconductor device according to some embodiments;
FIG. 9 is a plan view of a semiconductor device according to some embodiments;
FIG. 10 is a plan view of a semiconductor device according to embodiments;
FIG. 11 is a plan view of a semiconductor device according to embodiments;
FIGS. 12A, 12B, 12C, and 12D are cross-sectional views of a semiconductor device according to some embodiments; and
FIGS. 13A, 13B, 13C, 13D, 14A, 14B, 14C, 14D, 15A, 15B, 15C and 15D are cross-sectional views for describing a method for manufacturing a semiconductor device according to some embodiments.

### DETAILED DESCRIPTION

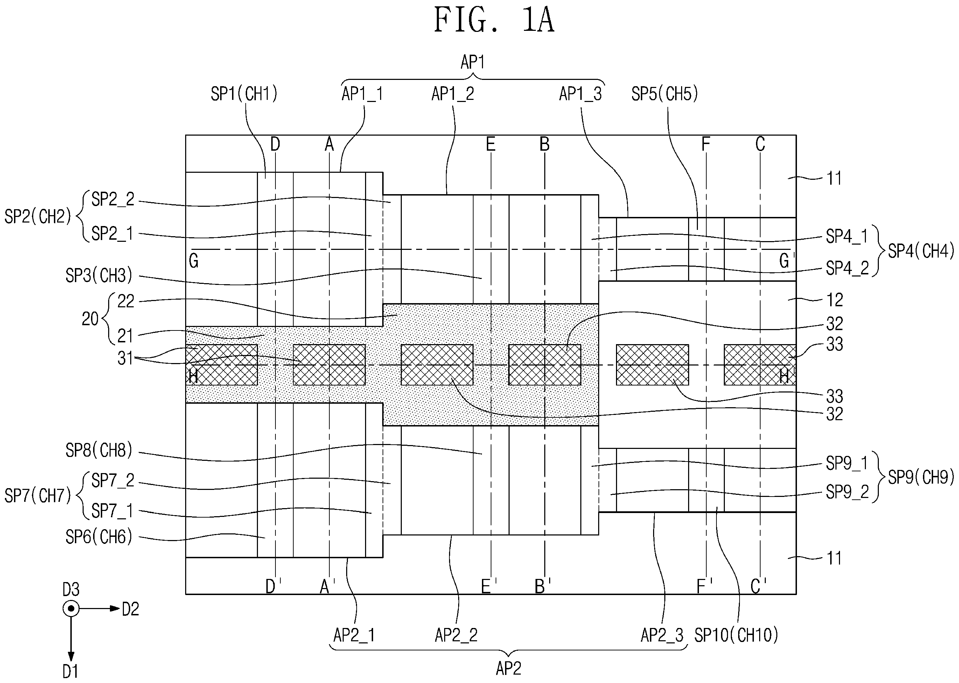

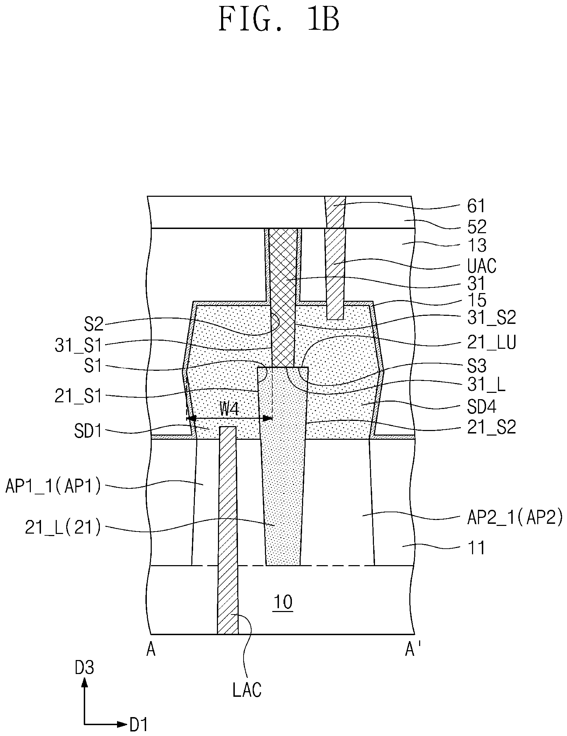

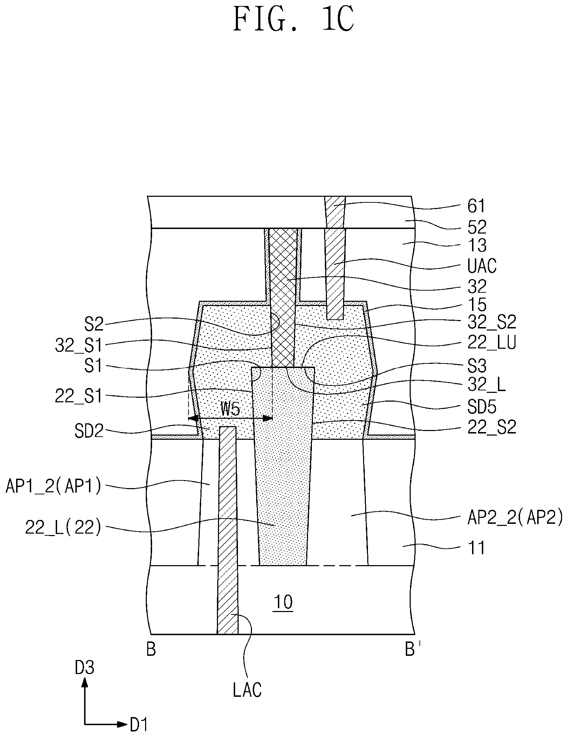

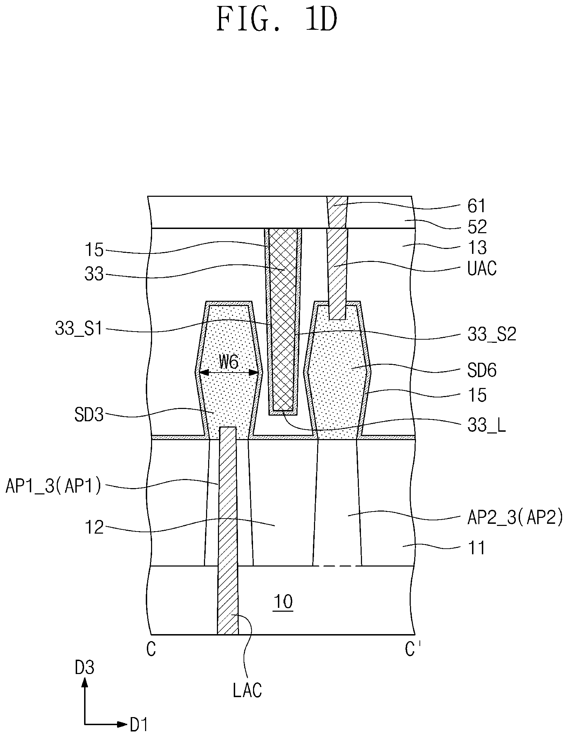

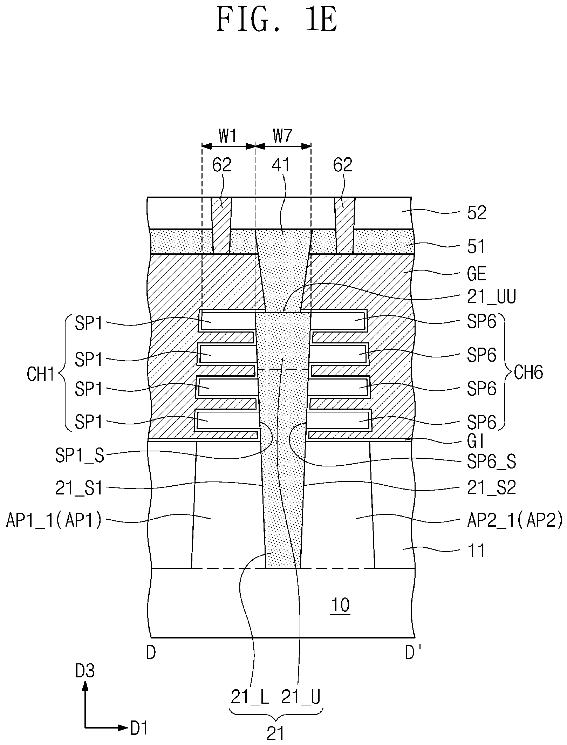

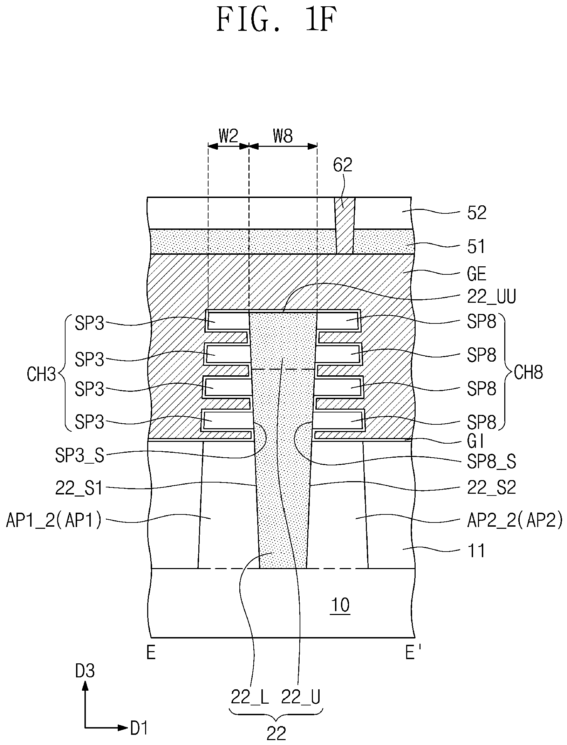

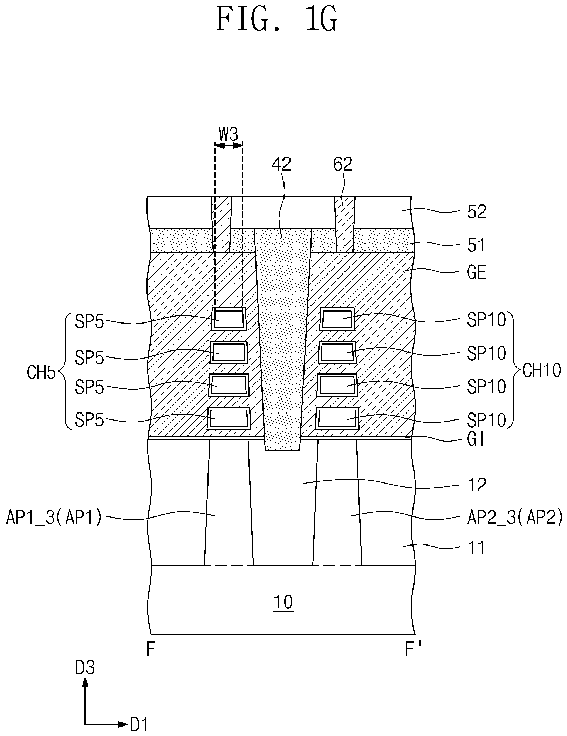

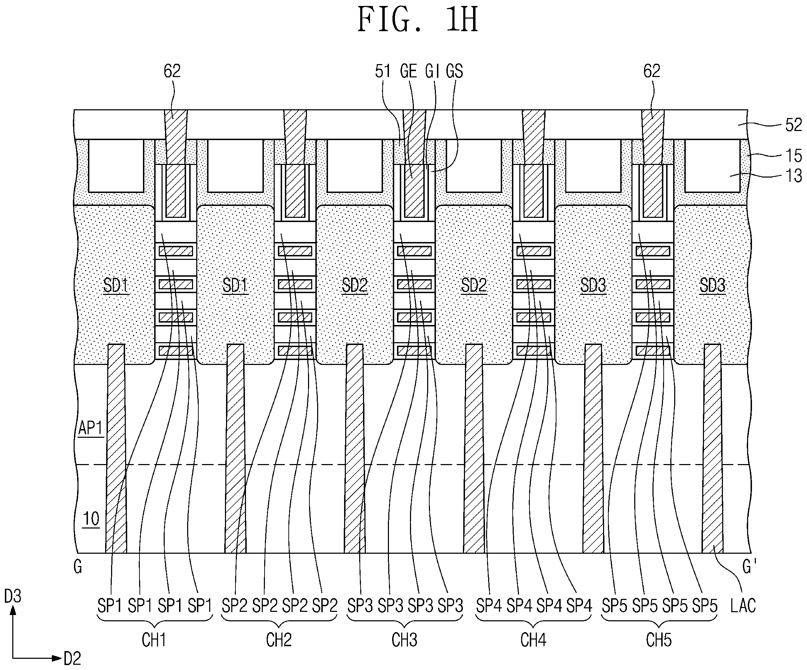

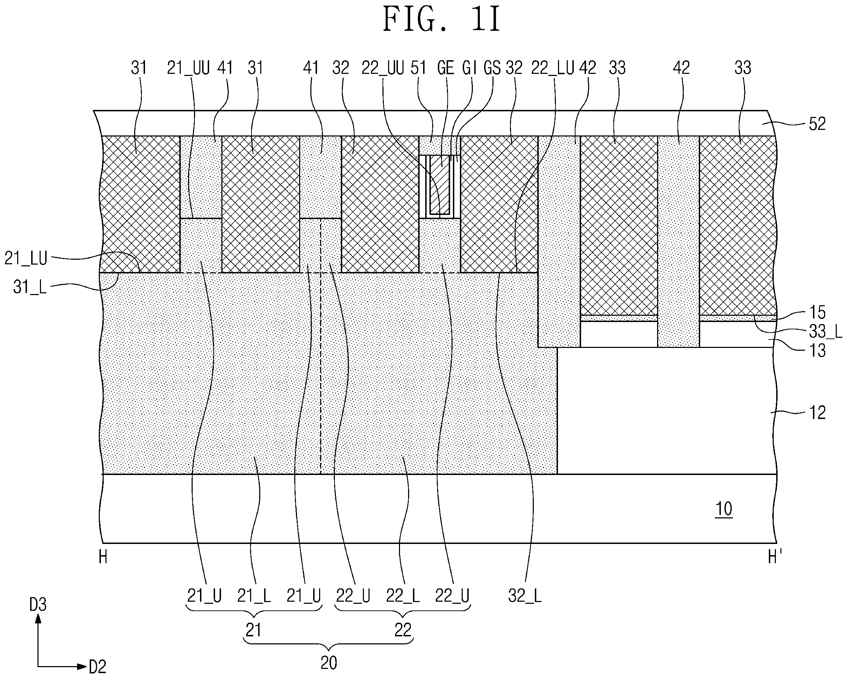

FIG. 1A is a plan view of a semiconductor device according to some embodiments. FIG. 1B is a cross-sectional view taken along line A-A' of FIG. 1A. FIG. 1C is a cross-sectional view taken along line B-B' of FIG. 1A. FIG. 1D is a cross-sectional view taken along line C-C' of FIG. 1A. FIG. 1E is a cross-sectional view taken along line D-D' of FIG. 1A. FIG. 1F is a cross-sectional view taken along line E-E' of FIG. 1A. FIG. 1G is a cross-sectional view taken along line C-C' of FIG. 1A. FIG. 1H is a cross-sectional view taken along line G-G' of FIG. 1A. FIG. 1I is a cross-sectional view taken along line H-H' of FIG. 1A.

Referring to FIGS. 1A to 1I, a semiconductor device may include a substrate 10. Logic transistors that constitute a logic circuit may be disposed on the substrate 10. The substrate 10 may be a semiconductor substrate, an insulator substrate, a silicon-on-insulator (SOI) substrate, or a germanium-on-insulator (GOI) substrate. For example, the semiconductor substrate may include silicon, germanium, silicon-germanium, gallium phosphide (GaP), or gallium arsenide (GaAs).

The substrate 10 may have a form of a plate extending along a plane defined by a first direction D1 and a second direction D2. The first direction D1 and the second direction D2 may cross each other (e.g. may be perpendicular to each other). For example, the first direction and the second direction D2 may be horizontal directions perpendicular to each other.

A substrate 10 may include a first active pattern AP1 and a second active pattern AP2. The first and second active patterns AP1 and AP2 may extend in the second direction D2. The first and second active patterns AP1 and AP2 may be spaced apart from each other in the first direction D1. The first and second active patterns AP1 and AP2 may be upper portions of the substrate 10 protruding in a third direction D3. The third direction D3 may cross the first direction D1 and the second direction D2 (e.g. may be perpendicular to the first direction D1 and the second direction D2). For example, the third direction D3 may be a vertical direction of the first direction D1 and the second direction D2. The third direction D3 may define a height direction. Features that are described as "above" or "higher" than other features may be located further along the third direction D3 than the other features. Whilst the terms "vertical" and "horizontal" are used herein, it will be appreciated that these are defined relative to the structure of the semiconductor device, and need not imply any particular orientation of the semiconductor device in use.

First element isolation layers 11 may be provided on the substrate 10. The first and second active patterns AP1 and AP2 may be disposed between the first element isolation layers 11 spaced apart from each other in the first direction D1. The first element isolation layers 11 may include an insulating material. For example, the first element isolation layers 11 may include an oxide.

A second element isolation layer 12 may be provided on the substrate 10. The second element isolation layer 12 may be disposed between the first and second active patterns AP1 and AP2. The second element isolation layer 12 may be disposed between a third part AP1_3 of the first active pattern AP1 and a third part AP2_3 of the second active pattern AP2. The second element isolation layer 12 may include an insulating material. For example, the second element isolation layer 12 may include an oxide.

A first channel structure CH1, a second channel structure CH2, a third channel structure CH3, a fourth channel structure CH4 and a fifth channel structure CH5 overlapping in the second direction D2 may be provided in the first active pattern AP1. A sixth channel structure CH6, a seventh channel structure CH7, an eighth channel structure CH8, a ninth channel structure CH9 and a tenth channel structure CH10 overlapping in the second direction D2 may be provided in the second active pattern AP2. As used herein, "an element A overlapping an element B in a direction X" (or similar language) means that there is at least one line that extends in the direction X and intersects (at least a portion of) both the elements A and B.

The first to fifth channel structures CH1 to CH5 may be arranged spaced apart from each other in the second direction D2. The sixth to tenth channel structures CH6 to CH10 may be arranged spaced apart from each other in the second direction D2.

The first channel structure CH1 may include first semiconductor patterns SP1 arranged spaced apart from each other in the third direction D3. The first semiconductor patterns SP1 may overlap each other in the third direction D3. The second channel structure CH2 may include second semiconductor patterns SP2 arranged spaced apart from each other in the third direction D3. The third channel structure CH3 may include third semiconductor patterns SP3 arranged spaced apart from each other in the third direction D3. The fourth channel structure CH4 may include fourth semiconductor patterns SP4 arranged spaced apart from each other in the third direction D3. The fifth channel structure CH5 may include fifth semiconductor patterns SP5 arranged spaced apart from each other in the third direction D3. The sixth channel structure CH6 may include sixth semiconductor patterns SP6 arranged spaced apart from each other in the third direction D3. The seventh channel structure CH7 may include seventh semiconductor patterns SP7 arranged spaced apart from each other in the third direction D3. The eighth channel structure CH8 may include eighth semiconductor patterns SP8 arranged spaced apart from each other in the third direction D3. The ninth channel structure CH9 may include ninth semiconductor patterns SP9 arranged spaced apart from each other in the third direction D3. The tenth channel structure CH10 may include tenth semiconductor patterns SP10 arranged spaced apart from each other in the third direction D3.

A number of the semiconductor patterns SP1 to SP10 included in one of the channel structures CH1 to CH10 need not be limited to what is illustrated. According to some embodiments, a number of the semiconductor patterns SP1 to SP10 included in one of the channel structures CH1 to CH10 may be less than or equal to 3 or greater than or equal to 5. That is, each of the channel structures CH1 to CH10 may include one or more semiconductor patterns SP1 to SP10.

According to some embodiments, the semiconductor patterns SP1 to SP10 may include silicon (Si). For example, the semiconductor patterns SP1 to SP10 may include crystalline silicon.

First source/drain patterns SD1, second source/drain patterns SD2, and third source/drain patterns SD3 may be provided on the first active pattern AP1. Fourth source/drain patterns SD4, fifth source/drain patterns SD5, and sixth source/drain patterns SD6 may be provided on the second active pattern AP2.

The first source/drain pattern SD1 may be in contact with the first semiconductor patterns SP1. The second source/drain pattern SD2 may be in contact with the third semiconductor patterns SP3. The third source/drain pattern SD3 may be in contact with the fifth semiconductor patterns SP5. The fourth source/drain pattern SD4 may be in contact with the sixth semiconductor patterns SP6. The fifth source/drain pattern SD5 may be in contact with the eighth semiconductor patterns SP8. The sixth source/drain pattern SD6 may be in contact with the tenth semiconductor patterns SP10.

The source/drain patterns SD1 to SD6 may be each an epitaxial pattern formed in a selective epitaxial growth process. For example, the source/drain patterns SD1 to SD6 may each include silicon (Si) or silicon-germanium (SiGe).

According to some embodiments, a lower source/drain pattern may be provided under each of the source/drain patterns SD1 to SD6. The lower source/drain pattern may be provided in the active patterns AP1 and AP2.

A lower isolation insulating layer 20 may be provided. The lower isolation insulating layer 20 may extend in the second direction D2. The lower isolation insulating layer 20 may be disposed between the first and second active patterns AP1 and AP2, between the first and sixth semiconductor patterns SP1 and SP6, between the second and seventh semiconductor patterns SP2 and SP7, between the third and eighth semiconductor patterns SP3 and SP8, between the fourth and ninth semiconductor patterns SP4 and SP9, between the first and fourth source/drain patterns SD1 and SD4 and between the second and fifth source/drain patterns SD2 and SD5.

The first and sixth semiconductor patterns SP1 and SP6 may be arranged in the first direction D1 with the lower isolation insulating layer 20 therebetween. As used herein, the term "arranged in the X direction" may mean "spaced in a direction X", "spaced apart in a direction X", or "arranged in a line parallel to a direction X". The first and sixth semiconductor patterns SP1 and SP6 may be disposed on a straight line extending in the first direction D1. The second and seventh semiconductor patterns SP2 and SP7 may be arranged in the first direction D1 with the lower isolation insulating layer 20 therebetween. The third and eighth semiconductor patterns SP3 and SP8 may be arranged in the first direction D1 with the lower isolation insulating layer 20 therebetween. The fourth and ninth semiconductor patterns SP4 and SP9 may be arranged in the first direction D1 with the lower isolation insulating layer 20 therebetween. The fifth and tenth semiconductor patterns SP5 and SP10 may be arranged in the first direction D1.

The first and fourth source/drain patterns SD1 and SD4 may be arranged in the first direction D1 with the lower isolation insulating layer 20 therebetween. The first and fourth source/drain patterns SD1 and SD4 may be disposed on a straight line extending in the first direction D1. The second and fifth source/drain patterns SD2 and SD5 may be arranged in the first direction D1 with the lower isolation insulating layer 20 therebetween. The third and sixth source/drain patterns SD3 and SD6 may be arranged in the first direction D1.

The lower isolation insulating layer 20 may include an insulating material. For example, the lower isolation insulating layer 20 may include at least one of a nitride or an oxide.

A width of the first semiconductor pattern SP1 in the first direction D1 may be greater than a width of the third semiconductor pattern SP3 in the first direction D1. A minimum width W1 of the first semiconductor pattern SP1 disposed at the top among the first semiconductor patterns SP1 in the first direction D1 may be greater than a minimum width W2 of the third semiconductor pattern SP3 disposed at the top among the third semiconductor patterns SP3 in the first direction D1. According to some embodiments, the minimum width W1 of the first semiconductor pattern SP1 disposed at the top among the first semiconductor patterns SP1 in the first direction D1 may be greater than a maximum width of the third semiconductor pattern SP3 disposed at the bottom among the third semiconductor patterns SP3 in the first direction D1.

The width of the third semiconductor pattern SP3 in the first direction D1 may be greater than a width of the fifth semiconductor pattern SP5 in the first direction D1. The minimum width W2 of the third semiconductor pattern SP3 disposed at the top among the third semiconductor patterns SP3 in the first direction D1 may be greater than a minimum width W3 of the fifth semiconductor pattern SP5 disposed at the top among the fifth semiconductor patterns SP5 in the first direction D1. According to some embodiments, the minimum width W2 of the third semiconductor pattern SP3 disposed at the top among the third semiconductor patterns SP3 in the first direction D1 may be greater than a maximum width of the fifth semiconductor pattern SP5 disposed at the bottom among the fifth semiconductor patterns SP5 in the first direction D1.

The second semiconductor pattern SP2 may include a first part SP2_1 adjacent to (e.g. closest to, or facing) the first semiconductor pattern SP1 and a second part SP2_2 adjacent to (e.g. closest to, or facing) the third semiconductor pattern SP3. A width of the first part SP2_1 of the second semiconductor pattern SP2 in the first direction D1 may be greater than a width of the second part SP2_2 of the second semiconductor pattern SP2 in the first direction D1. According to some embodiments, the width of the first part SP2_1 of the second semiconductor pattern SP2 in the first direction D1 may be the same as a width of the first semiconductor pattern SP1 in the first direction D1. According to some embodiments, the width of the second part SP2_2 of the second semiconductor pattern SP2 in the first direction D1 may be the same as a width of the third semiconductor pattern SP3 in the first direction D1.

The fourth semiconductor pattern SP4 may include a first part SP4_1 adjacent to (e.g. closest to, or facing) the third semiconductor pattern SP3 and a second part SP4_2 adjacent to (e.g. closest to, or facing) the fifth semiconductor pattern SP5. A width of the first part SP4_1 of the fourth semiconductor pattern SP4 in the first direction D1 may be greater than a width of the second part SP4_2 of the fourth semiconductor pattern SP4 in the first direction D1. According to some embodiments, the width of the first part SP4_1 of the fourth semiconductor pattern SP4 in the first direction D1 may be the same as a width of the third semiconductor pattern SP3 in the first direction D1. According to some embodiments, the width of the second part SP4_2 of the fourth semiconductor pattern SP4 in the first direction D1 may be the same as a width of the fifth semiconductor pattern SP5 in the first direction D1.

A width of the sixth semiconductor pattern SP6 in the first direction D1 may be greater than a width of the eighth semiconductor pattern SP8 in the first direction D1. The width of the eighth semiconductor pattern SP8 in the first direction D1 may be greater than a width of the tenth semiconductor pattern SP10 in the first direction D1. The seventh semiconductor pattern SP7 may include a first part SP7_1 adjacent to (e.g. closest to, or facing) the sixth semiconductor pattern SP6 and a second part SP7_2 adjacent to (e.g. closest to, or facing) the eighth semiconductor pattern SP8. A width of the first part SP7_1 of the seventh semiconductor pattern SP7 in the first direction D1 may be greater than a width of the second part SP7_2 of the seventh semiconductor pattern SP7 in the first direction D1. The ninth semiconductor pattern SP9 may include a first part SP9_1 adjacent to (e.g. closest to, or facing) the eighth semiconductor pattern SP8 and a second part SP9_2 adjacent to (e.g. closest to, or facing) the tenth semiconductor pattern SP10. A width of the first part SP9_1 of the ninth semiconductor pattern SP9 in the first direction D1 may be greater than a width of the second part SP9_2 of the ninth semiconductor pattern SP9 in the first direction D1.

According to some embodiments, a width of the first semiconductor pattern SP1 in the first direction D1 may be the same as a width of the sixth semiconductor pattern SP6 in the first direction D1. According to some embodiments, a width of the third semiconductor pattern SP3 in the first direction D1 may be the same as a width of the eighth semiconductor pattern SP8 in the first direction D1. According to some embodiments, a width of the fifth semiconductor pattern SP5 in the first direction D1 may be the same as a width of the tenth semiconductor pattern SP10 in the first direction D1.

According to some embodiments, a diffusion prevention insulating layer may be provided in at least one of positions in which the second, fourth, seventh, and ninth semiconductor patterns SP2, SP4, SP7, and SP9 are disposed. Source/drain patterns disposed on both sides of the diffusion prevention insulating layer may be electrically separated by the diffusion prevention insulating layer.

A width of the first source/drain pattern SD1 in the first direction D1 may be greater than a width of the second source/drain pattern SD2 in the first direction D1. A maximum width W4 of the first source/drain pattern SD1 in the first direction D1 may be greater than a maximum width W5 of the second source/drain pattern SD2 in the first direction D1. A width of the second source/drain pattern SD2 in the first direction D1 may be greater than a width of the third source/drain pattern SD3 in the first direction D1. A maximum width W5 of the second source/drain pattern SD2 in the first direction D1 may be greater than a maximum width W6 of the third source/drain pattern SD3 in the first direction D1.

A width of the fourth source/drain pattern SD4 in the first direction D1 may be greater than a width of the fifth source/drain pattern SD5 in the first direction D1. A maximum width of the fourth source/drain pattern SD4 in the first direction D1 may be greater than a maximum width of the fifth source/drain pattern SD5 in the first direction D1. A width of the fifth source/drain pattern SD5 in the first direction D1 may be greater than a width of the sixth source/drain pattern SD6 in the first direction D1. A maximum width of the fifth source/drain pattern SD5 in the first direction D1 may be greater than a maximum width of the sixth source/drain pattern SD6 in the first direction D1.

The first active pattern AP1 may include a first part AP1_1 overlapping the first and second semiconductor patterns SP1 and SP2 in the third direction D3, a second part AP1_2 overlapping the second, third, and fourth semiconductor patterns SP2, SP3, and SP4 in the third direction D3, and a third part AP1_3 overlapping the fourth and fifth semiconductor patterns SP4 and SP5 in the third direction D3. A width of the first part AP1_1 of the first active pattern AP1 in the first direction D1 may be greater than a width of the second part AP1_2 of the first active pattern AP1 in the first direction D1. A width of the second part AP1_2 of the first active pattern AP1 in the first direction D1 may be greater than a width of the third part AP1_3 of the first active pattern AP1 in the first direction D1.

The second active pattern AP2 may include a first part AP2_1 overlapping the sixth and seventh semiconductor patterns SP6 and SP7 in the third direction D3, a second part AP2_2 overlapping the seventh to ninth semiconductor patterns SP7, SP8, and SP9 in the third direction D3, and a third part AP2_3 overlapping the ninth and tenth semiconductor patterns SP9 and SP10 in the third direction D3. A width of the first part AP2_1 of the second active pattern AP2 in the first direction D1 may be greater than a width of the second part AP22 of the second active pattern AP2 in the first direction D1. A width of the second part AP2_2 of the second active pattern AP2 in the first direction D1 may be greater than a width of the third part AP2_3 of the second active pattern AP2 in the first direction D1.

The lower isolation insulating layer 20 may include a first isolation portion 21 between the first and sixth semiconductor patterns SP1 and SP6 and a second isolation portion 22 between the third and eighth semiconductor patterns SP3 and SP8. The first isolation portion 21 may be disposed between the first and fourth source/drain patterns SD1 and SD4. The second isolation portion 22 may be disposed between the second and fifth source/drain patterns SD2 and SD5.

A width of the first isolation portion 21 in the first direction D1 may be smaller than a width of the second isolation portion 22 in the first direction D1. A maximum width W7 of the first isolation portion 21 in the first direction D1 may be smaller than a maximum width W8 of the second isolation portion 22 in the first direction D1.

The first isolation portion 21 may include a lower portion 21_L and upper portions 21_U. The upper portions 21_U of the first isolation portion 21 may be disposed on the lower portion 21_L of the first isolation portion 21. The upper portions 21_U of the first isolation portion 21 may be disposed at a higher level than the lower portion 21_L of the first isolation portion 21. The upper portions 21_U of the first isolation portion 21 may be arranged spaced apart from each other in the second direction D2.

The second isolation portion 22 may include a lower portion 22_L and upper portions 22_U. The upper portions 22_U of the second isolation portion 22 may be disposed on the lower portion 22_L of the second isolation portion 22. The upper portions 22_U of the second isolation portion 22 may be disposed at a higher level than the lower portion 22_L of the second isolation portion 22. The upper portions 22_U of the second isolation portion 22 may be arranged spaced apart from each other in the second direction D2.

First upper isolation insulating layers 31, second upper isolation insulating layers 32 and third upper isolation insulating layers 33 may be provided. The first upper isolation insulating layers 31 may be provided on the lower portion 21_L of the first isolation portion 21. A lower surface 31_L of the first upper isolation insulating layers 31 may be in contact with an upper surface 21_LU of the lower portion 21_L of the first isolation portion 21. The first upper isolation insulating layer 31 may be disposed between the upper portions 21_U of the first isolation portion 21. The lower surface 31_L of the first upper isolation insulating layer 31 may be disposed at a lower level than an upper surface 21_UU of the upper portion 21_U of the first isolation portion 21. The first upper isolation insulating layer 31 may be disposed between the first and fourth source/drain patterns SD1 and SD4. A width of the first upper isolation insulating layer 31 in the first direction D1 may be smaller than a width of the first isolation portion 21 in the first direction D1.

The first upper isolation insulating layer 31 may include a first sidewall 31_S1 and a second sidewall 31_S2 opposed to each other. The first isolation portion 21 may include a first sidewall 21_S1 and a second sidewall 21_S2 opposed to each other.

Second upper isolation insulating layers 32 may be provided on the lower portion 22_L of the second isolation portion 22. A lower surface 32_L of the second upper isolation insulating layer 32 may be in contact with an upper surface 22_LU of the lower portion 22_L of the second isolation portion 22. The second upper isolation insulating layer 32 may be disposed between the upper portions 22_U of the second isolation portion 22. The lower surface 32_L of the second upper isolation insulating layer 32 may be disposed at a lower level than an upper surface 22_UU of the upper portion 22_U of the second isolation portion 22. The second upper isolation insulating layer 32 may be disposed between the second and fifth source/drain patterns SD2 and SD5. A width of the second upper isolation insulating layer 32 in the first direction D1 may be smaller than a width of the second isolation portion 22 in the first direction D1.

The second upper isolation insulating layer 32 may include a first sidewall 32_S1 and a second sidewall 32_S2 opposed to each other. The second isolation portion 22 may include a first sidewall 22_S1 and a second sidewall 22_S2 opposed to each other.

A lower surface 33_L of the third upper isolation insulating layer 33 may have a lower level than the lower surfaces 31_L and 32_L of the first and second upper isolation insulating layers 31 and 32. The third upper isolation insulating layer 33 may have a greater height (for example, a length, depth or thickness in the third direction D3) than the first and second upper isolation insulating layers 31 and 32. The third upper isolation insulating layer 33 may be disposed between the second and sixth source/drain patterns SD3 and SD6. The third upper isolation insulating layer 33 may include a first sidewall 33_S1 and a second sidewall 33_S2 opposed to each other.

Each of the first, second, fourth, and fifth source/drain patterns SD1, SD2, SD4, and SD5 may include a first sidewall S1 in contact with the lower isolation insulating layer 20, a second sidewall S2 in contact with the upper isolation insulating layers 31 and 32 and a surface S3 connecting the first sidewall S1 and the second sidewall S2.

The first sidewalls S1 of the first and fourth source/drain patterns SD1 and SD4 may be respectively in contact with the first and second sidewalls 21_S1 and 21_S2 of the first isolation portion 21. The second sidewalls S2 of the first and fourth source/drain patterns SD1 and SD4 may be respectively in contact with the first and second sidewalls 31_S1 and 31_S2 of the first upper isolation insulating layers 31. The surfaces S3 of the first and fourth source/drain patterns SD1 and SD4 may be in contact with the upper surface 21_LU of the lower portion 21_L of the first isolation portion 21.

The first sidewalls S1 of the second and fifth source/drain patterns SD2 and SD5 may be respectively in contact with the first and second sidewalls 22_S1 and 22_S2 of the second isolation portion 22. The second sidewalls S2 of the second and fifth source/drain patterns SD2 and SD5 may be respectively in contact with the first and second sidewalls 32_S1 and 32_S2 of the second upper isolation insulating layer 32. The surfaces S3 of the second and fifth source/drain patterns SD2 and SD5 may be in contact with the upper surface 22_LU of the lower portion 22_L of the second isolation portion 22.

The third and sixth source/drain patterns SD3 and SD6 may be spaced apart from the lower isolation insulating layer 20 and the third upper isolation insulating layer 33.

A sidewall SP1_S of the first semiconductor pattern SP1 may be in contact with the first sidewall 21_S1 of the first isolation portion 21. A sidewall SP6_S of the sixth semiconductor pattern SP6 may be in contact with the second sidewall 21_S2 of the first isolation portion 21. A sidewall SP3_S of the third semiconductor pattern SP3 may be in contact with the first sidewall 22_S1 of the second isolation portion 22. A sidewall SP8_S of the eighth semiconductor pattern SP8 may be in contact with the second sidewall 22_S2 of the second isolation portion 22. The fifth and tenth semiconductor patterns SP5 and SP10 may be spaced apart from the lower isolation insulating layer 20.

Gate electrodes GE may be provided. The gate electrodes GE may extend in the first direction D1. The gate electrode GE may overlap the semiconductor patterns SP1 to SP10 in the third direction D3.

The gate electrode GE and the semiconductor patterns SP1 to SP10 may constitute a three-dimensional field effect transistor (for example, a MBCFET or GAAFET). The gate electrode GE may include a conductive material. According to some embodiments, the gate electrode GE may include a barrier layer and a conductive layer including different materials.

Gate insulating layers GI may be provided. The gate electrode GE and the semiconductor patterns SP1 to SP10 may be spaced apart from each other by the gate insulating layer GI. The gate insulating layer GI may be provided between the gate electrode GE and the semiconductor patterns SP1 to SP10. The gate electrode GE and the lower isolation insulating layer 20 may be spaced apart from each other by the gate insulating layer GI. The gate insulating layer GI may be provided between the gate electrode GE and the lower isolation insulating layer 20. The gate insulating layer GI may be in contact with a first element isolation layer 11, a second element isolation layer 12 and the lower isolation insulating layer 20. The gate insulating layer GI may include an insulating material. For example, the gate insulating layer GI may include silicon oxide.

Gate spacers GS may be provided. The gate spacers GS may be disposed on both sides of the gate electrode GE. The gate spacers GS may include an insulating material.

A cover insulating layer 15 may be provided. The cover insulating layer 15 may be in contact with the first element isolation layers 11, the second element isolation layer 12, source/drain patterns SD1 to SD6, the upper isolation insulating layers 31, 32 and 33, and the gate spacers GS. The cover insulating layer 15 may include an insulating material. An insulating layer 13 may be provided on the cover insulating layer 15. The insulating layer 13 may include an insulating material.

The first and second sidewalls 31_S1, 31_S2, 32_S1, 32_S2, 33_S1 and 33_S2 of the first to third upper isolation insulating layers 31, 32 and 33 may be in contact with the cover insulating layer 15. The lower surfaces 31_L and 32_L of the first and second upper isolation insulating layers 31 and 32 may be spaced apart from the cover insulating layer 15. The lower surface 33_L of the third upper isolation insulating layer 33 may be in contact with the cover insulating layer 15.

The cover insulating layer 15 may include a portion interposed between the third upper isolation insulating layer 33 and the third source/drain pattern SD3. The insulating layer 13 may include a portion interposed between the third upper isolation insulating layer 33 and the third source/drain pattern SD3.

A first gate cutting insulating layer 41 may be provided. The first gate cutting insulating layer 41 may be disposed between the gate electrodes GE spaced apart from each other in the first direction D1. The first gate cutting insulating layer 41 may be provided on the first isolation portion 21. The first gate cutting insulating layer 41 may be provided between the first and sixth semiconductor patterns SP1 and SP6. According to some embodiments, the first gate cutting insulating layer 41 may be provided between the third and eighth semiconductor patterns SP3 and SP8, and may be provided on the second isolation portion 22.

A second gate cutting insulating layer 42 may be provided. The second gate cutting insulating layer 42 may be disposed between the gate electrodes GE spaced apart from each other in the first direction D1. The second gate cutting insulating layer 42 may be provided on the second element isolation layer 12. The second gate cutting insulating layer 42 may be provided between the fifth and tenth semiconductor patterns SP5 and SP10. According to some embodiments, the second gate cutting insulating layer 42 may not be provided between the fifth and tenth semiconductor patterns SP5 and SP10.

The first gate cutting insulating layer 41 may have a smaller height (for example, a length, depth or thickness in the third direction D3) than the second gate cutting insulating layer 42. For instance, the first gate cutting insulating layer 41 may be shorter in the third direction D3 than the second gate cutting insulating layer 42. A level of a lower surface of the first gate cutting insulating layer 41 may be higher than a level of a lower surface of the second gate cutting insulating layer 42. The first and second gate cutting insulating layers 41 and 42 may include an insulating material.

Upper active contacts UAC may be provided. Each of the upper active contacts UAC may be in contact with one among the fourth to sixth source/drain patterns SD4 to SD6. Lower active contacts LAC may be provided. Each of the lower active contacts LAC may penetrate the active pattern AP1 or AP2 to be in contact with one among the first to third source/drain patterns SD1 to SD3. The upper active contact UAC and the lower active contact LAC may include a conductive material. The source/drain patterns SD1 to SD6 in contact with the upper active contact UAC and the lower active contact LAC may not be limited to what is illustrated. According to some embodiments, the upper active contact UAC may be in contact with the first source/drain pattern SD1, and the lower active contact LAC may be in contact with the fourth source/drain pattern SD4.

A capping insulating layer 51 may be provided on the gate electrodes GE. The capping insulating layer 51 may include an insulating material. An upper insulating layer 52 may be provided on the capping insulating layer 51. The upper insulating layer 52 may include an insulating material.

First contacts 61 may be provided. The first contact 61 may penetrate the upper insulating layer 52 to be in contact with the upper active contact UAC. Second contacts 62 may be provided. The second contact 62 may penetrate the upper insulating layer 52 and the capping insulating layer 51 to be in contact with the gate electrode GE. The first and second contacts 61 and 62 may include a conductive material.

Since a semiconductor device according to some embodiments includes semiconductor patterns having different widths, a degree of freedom in designing the semiconductor device may be improved.

Since in the semiconductor device according to some embodiments, the lower isolation insulating layer 20 thereof includes the first isolation portion 21 and the second isolation portion 22 having different widths, the degree of freedom in designing the semiconductor device may be improved.

Since in the semiconductor device according to some embodiments, a distance between the third and sixth source/drain patterns SD3 and SD6 is relatively great, it is not necessary to form the lower isolation insulating layer 20 between the third and sixth source/drain patterns SD3 and SD6. Accordingly, time and cost for a process of manufacturing the lower isolation insulating layer 20 may be saved.

Since the semiconductor device according to some embodiments includes the upper isolation insulating layers 31, 32 and 33, a phenomenon that the upper active contacts UAC are connected to each other may be prevented.

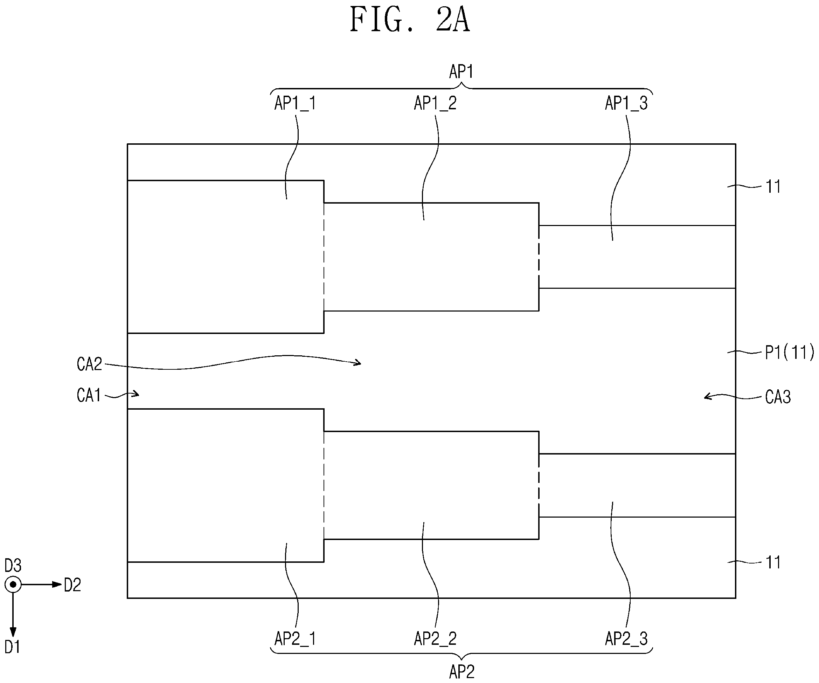

FIGS. 2A, 2B, 2C, 2D, 2E, 3A, 3B, 3C, 4A, 4B, 4C, 4D, 4E, 5A, 5B, 5C, 5D, 5E, 5F, 5G, 5H, 5I, 6A, 6B, 6C, 6D, 6E, 7A, 7B, 7C, 7D, 7E, 7F, 7G and 7H are diagrams for describing a method for manufacturing a semiconductor device according to some embodiments.

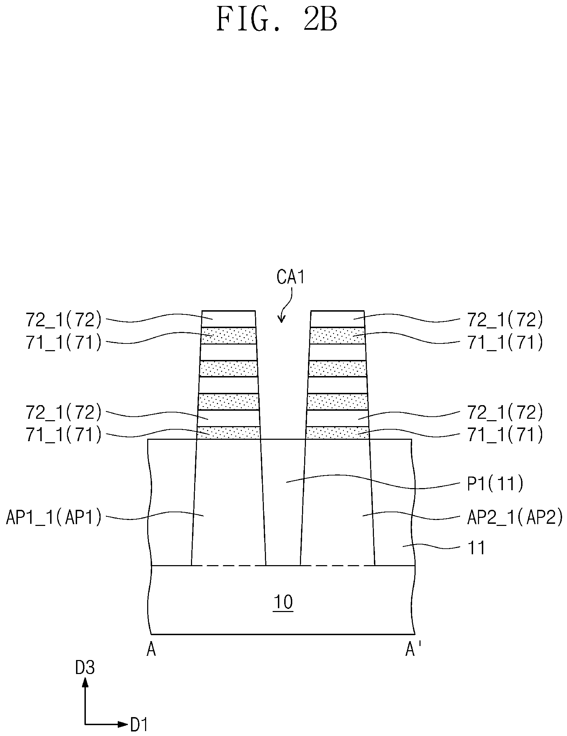

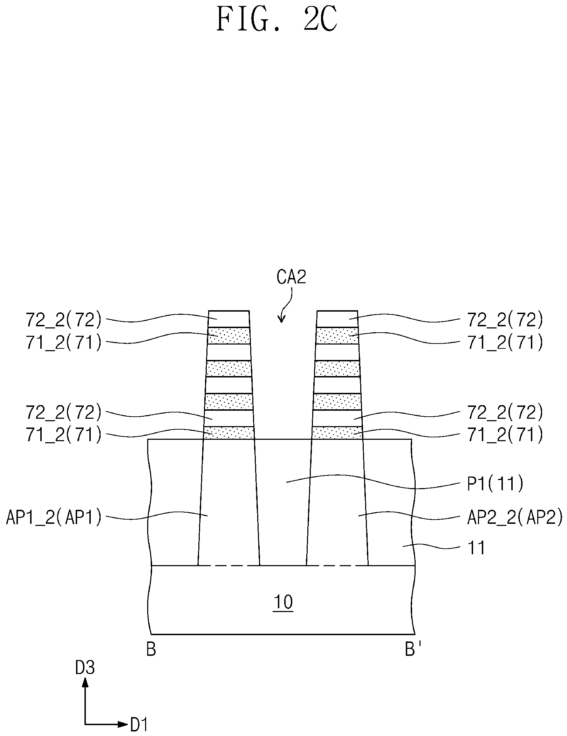

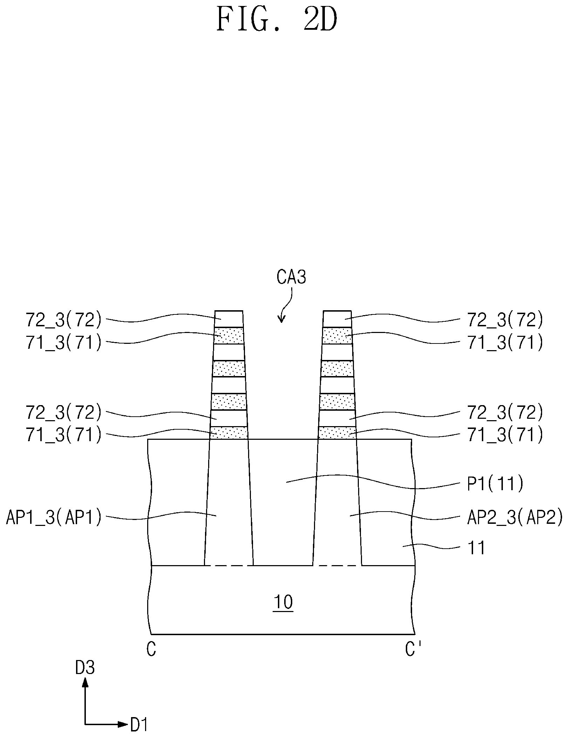

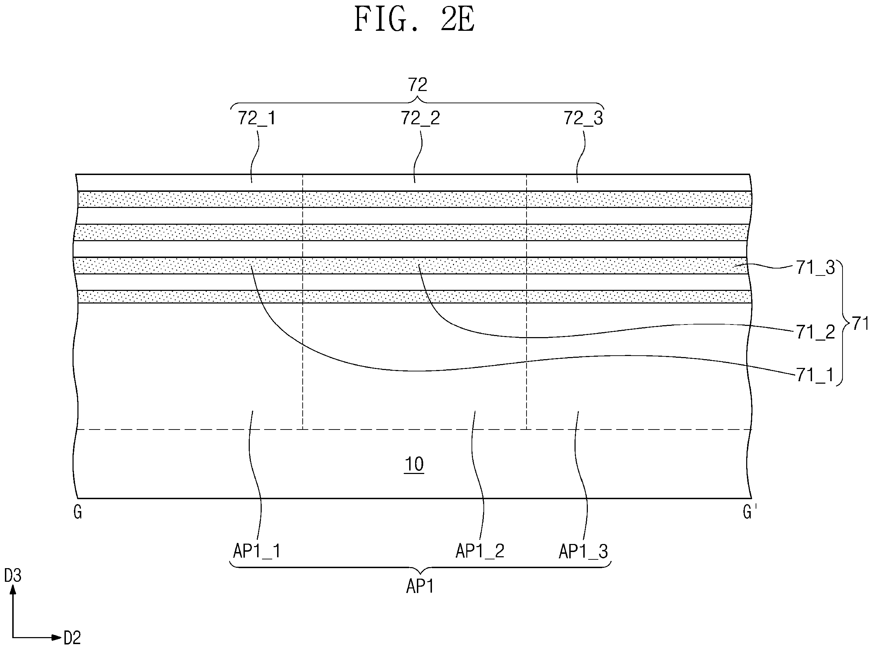

Referring to FIGS. 2A, 2B, 2C, 2D, and 2E, a first element isolation layer 11, first and second active patterns AP1 and AP2, sacrificial semiconductor layers 71, and semiconductor layers 72 may be formed.

An operation of forming the first element isolation layer 11, the first and second active patterns AP1 and AP2, the sacrificial semiconductor layers 71, and the semiconductor layers 72 may include an operation of alternately forming preliminary sacrificial semiconductor layers and preliminary semiconductor layers on a substrate 10, an operation of forming the first and second active patterns AP1 and AP2, the sacrificial semiconductor layers 71, and the semiconductor layers 72 by patterning the substrate 10, the preliminary sacrificial semiconductor layers and the preliminary semiconductor layers, and an operation of forming the first element isolation layer 11.

The sacrificial semiconductor layer 71 may include a material having etching selectivity for the semiconductor layer 72. For example, the sacrificial semiconductor layer 71 may include silicon-germanium (SiGe), and the semiconductor layer 72 may include silicon (Si).

Each of the first and second active patterns AP1 and AP2 may include first parts AP1_1 and AP2_1, second parts AP1_2 and AP2_2, and third parts AP1_3 and AP2_3. The sacrificial semiconductor layer 71 may have a similar form to the active pattern AP1 or AP2. The sacrificial semiconductor layer 71 may include a first part 71_1, a second part 71_2 having a smaller width than the first part 71_1, and a third part 71_3 having a smaller width than the second part 71_2. The semiconductor layer 72 may have a similar form to the active pattern AP1 or AP2. The semiconductor layer 72 may include a first part 72_1, a second part 72_2 having a smaller width than the first part 72_1, and a third part 72_3 having a smaller width than the second part 72_2.

A space between the first parts 71_1 and 72_1 of the sacrificial semiconductor layers 71 and the semiconductor layers 72 may be defined as a first cavity CA1. A space between the second parts 71_2 and 72_2 of the sacrificial semiconductor layers 71 and the semiconductor layers 72 may be defined as a second cavity CA2. A space between the third parts 71_3 and 72_3 of the sacrificial semiconductor layers 71 and the semiconductor layers 72 may be defined as a third cavity CA3. A width of the first cavity CA1 in the first direction D1 may be smaller than a width of the second cavity CA2 in the first direction D1. A width of the second cavity CA2 in the first direction D1 may be smaller than a width of the third cavity CA3 in the first direction D1.

The first element isolation layer 11 may include an interposition (e.g. an interposing portion) P1 interposed between the first and second active patterns AP1 and AP2. The first to third cavities CA1, CA2 and CA3 may be disposed on the interposition P1.

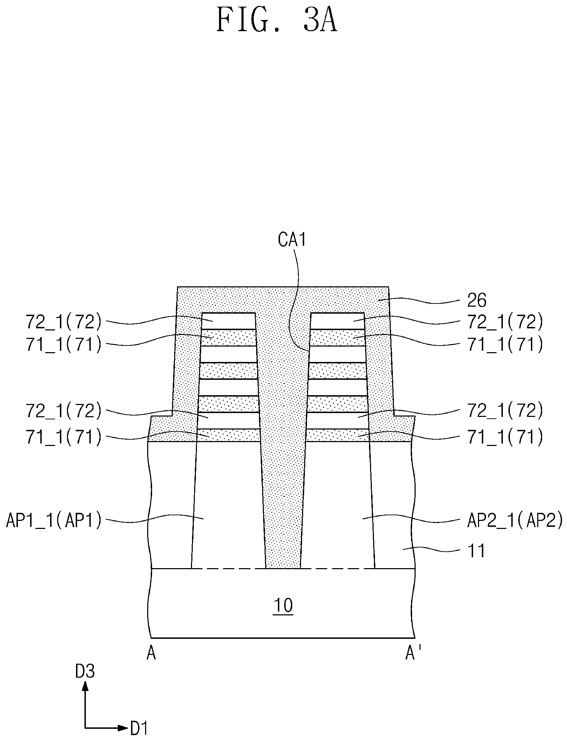

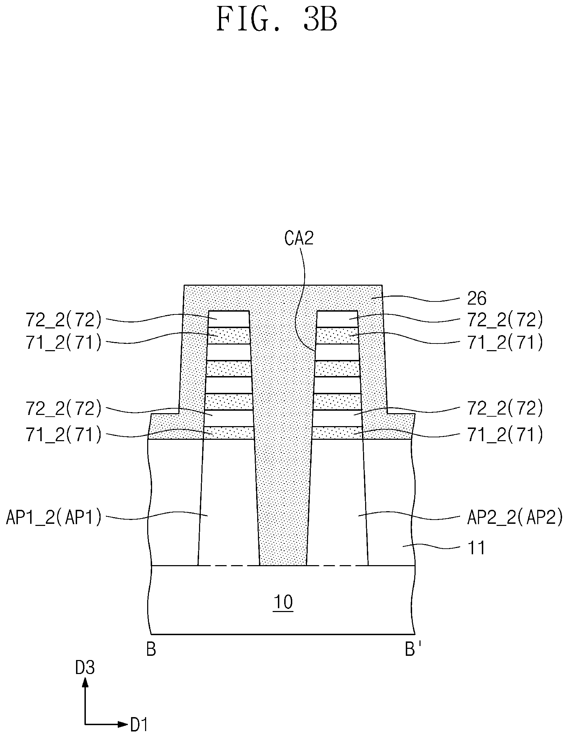

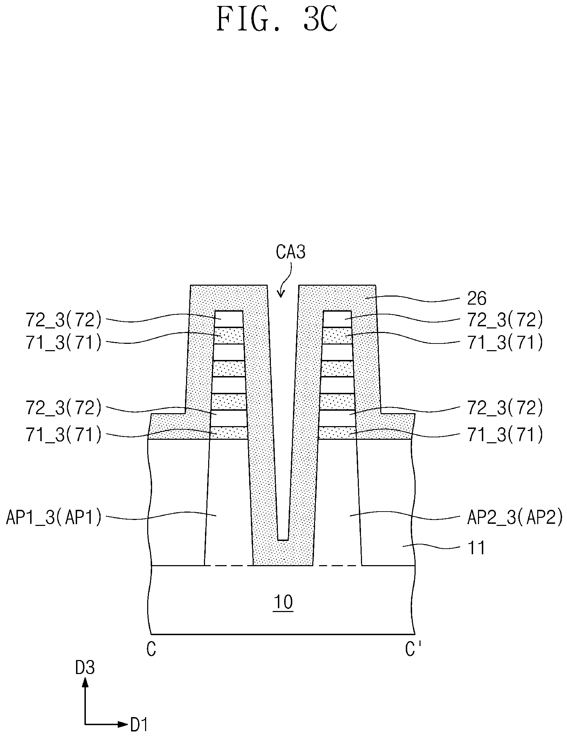

Referring to FIGS. 3A, 3B, and 3C, the interposition P1 of the first element isolation layer 11 may be removed. Thereafter, a preliminary insulating layer 26 may be formed. The preliminary insulating layer 26 may completely fill the first cavity CA1 and the second cavity CA2. The preliminary insulating layer 26 may partially fill the third cavity CA3.

The preliminary insulating layer 26 may include an insulating material. For example, the preliminary insulating layer 26 may include at least one of a nitride or an oxide.

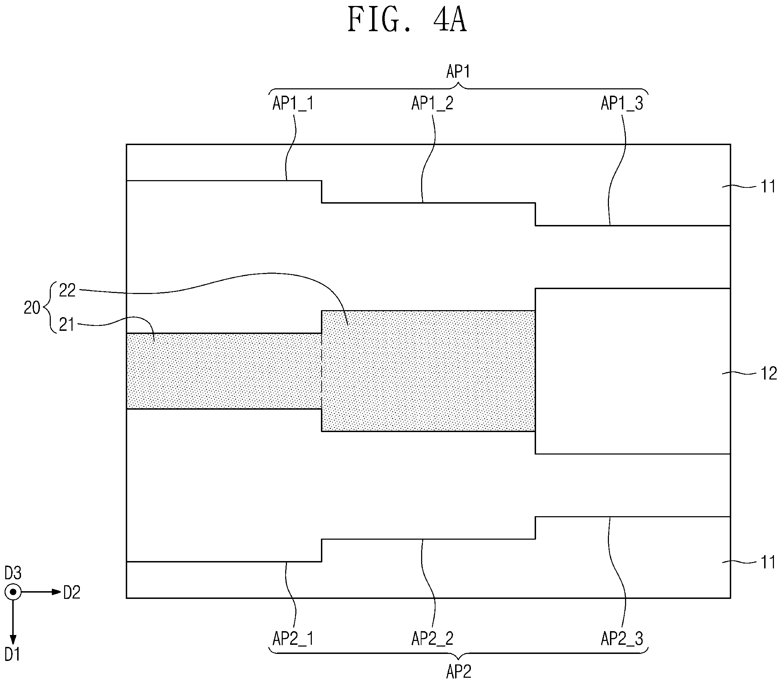

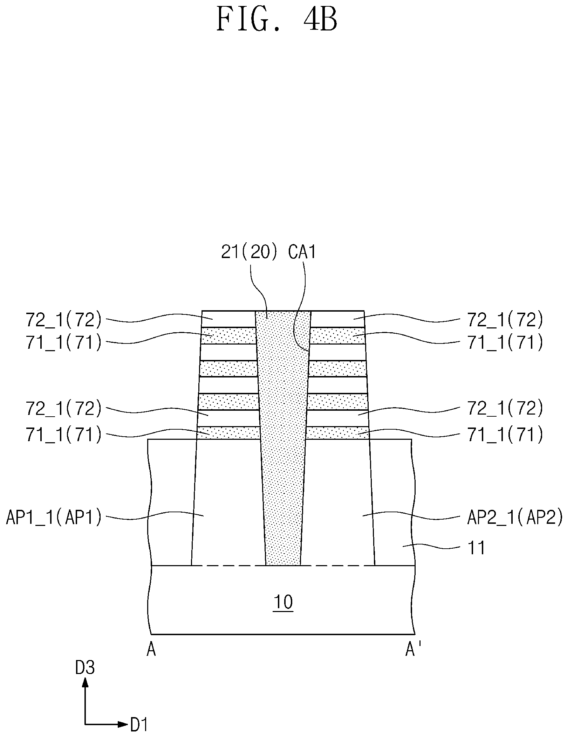

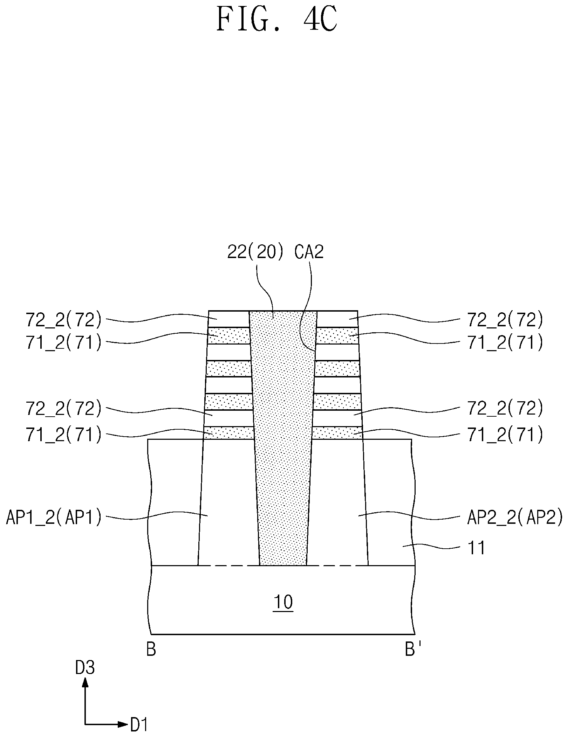

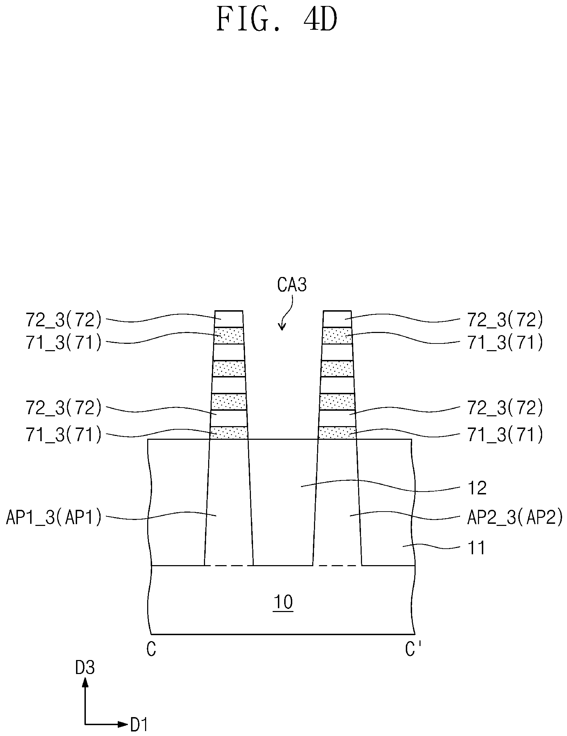

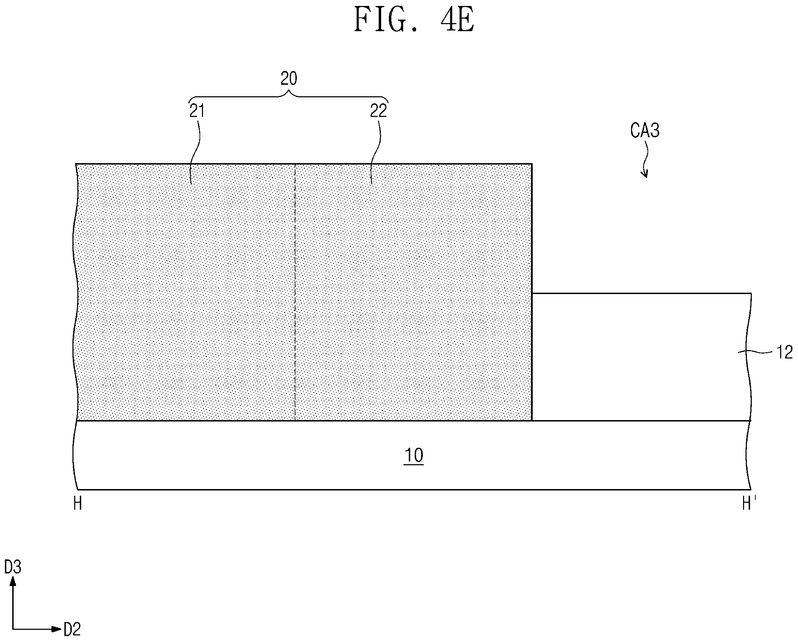

Referring to FIGS. 4A, 4B, 4C, 4D, and 4E, the preliminary insulating layer 26 may be etched. According to some embodiments, the preliminary insulating layer 26 may be etched through an isotropic etching process. A lower isolation insulating layer 20 may be formed by etching the preliminary insulating layer 26. The lower isolation insulating layer 20 may fill the first cavity CA1 and the second cavity CA2. The lower isolation insulating layer 20 may include a first isolation portion 21 that fills the first cavity CA1, and a second isolation portion 22 that fills the second cavity CA2.

The preliminary insulating layer 26 in the third cavity CA3 may be partially removed through the etching process. The preliminary insulating layer 26 may be partially removed to open the third cavity CA3. A second element isolation layer 12 may be formed between the third parts AP1_3 and AP2_3 of the first and second active patterns AP1 and AP2 through the third cavity CA3.

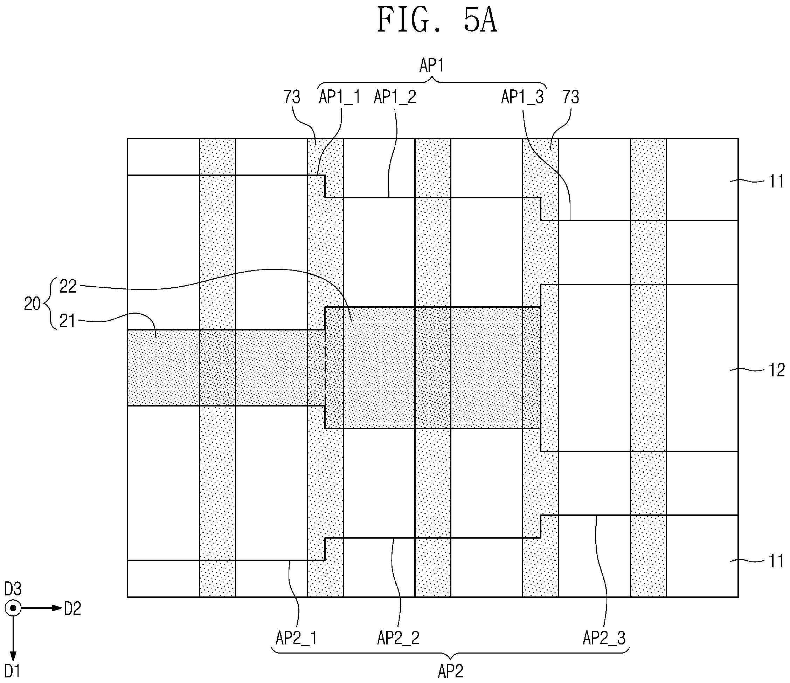

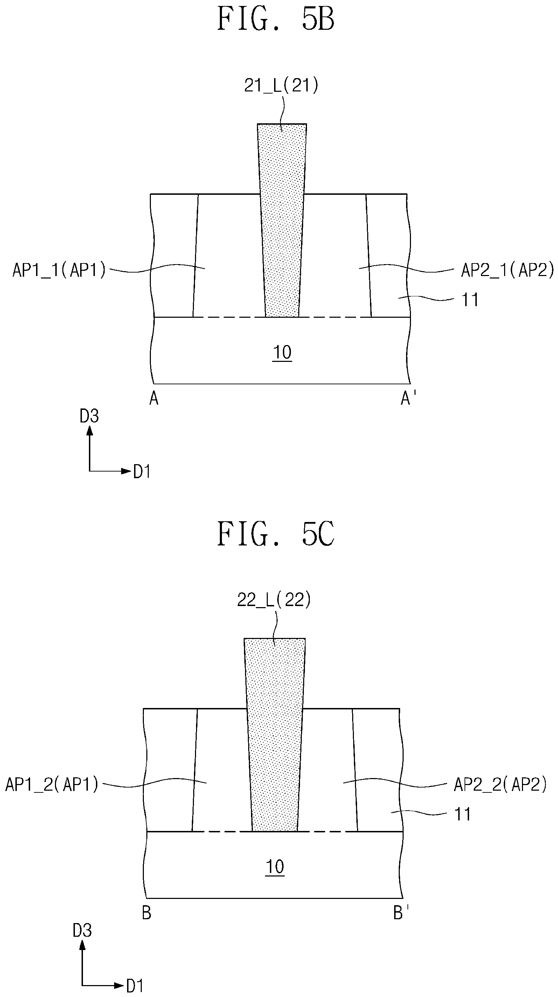

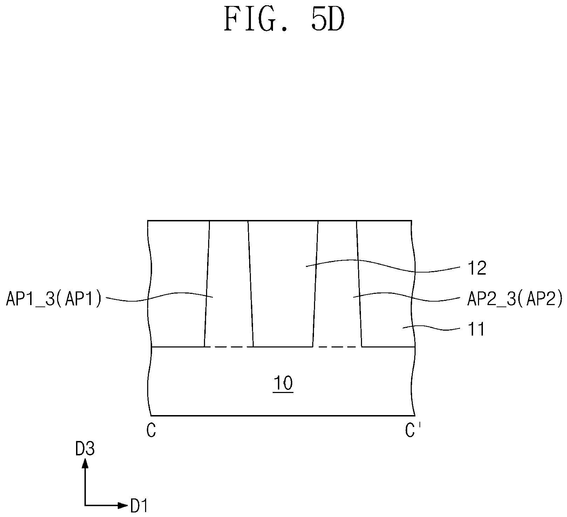

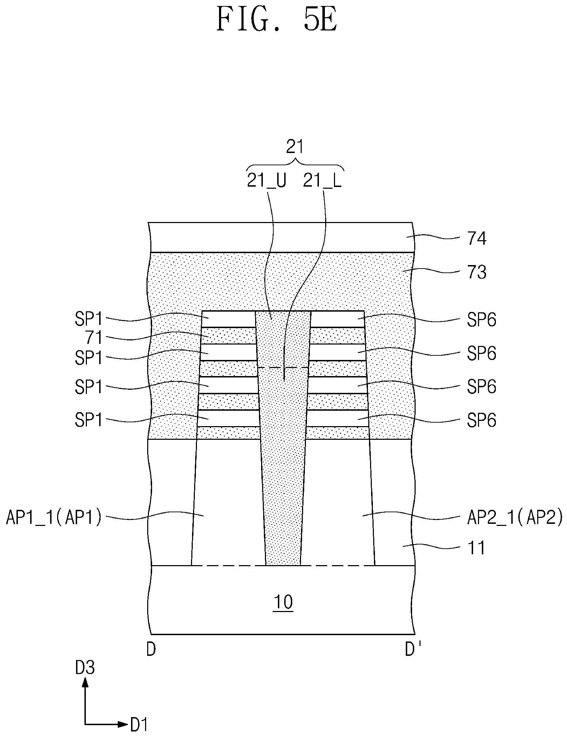

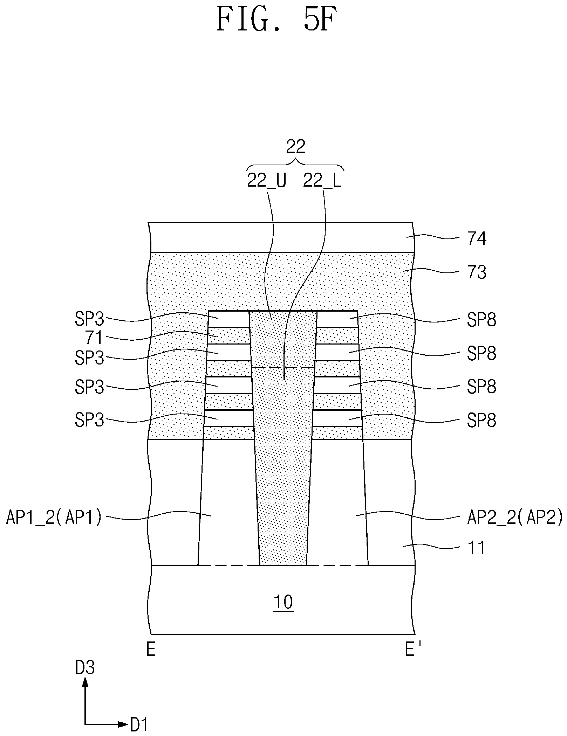

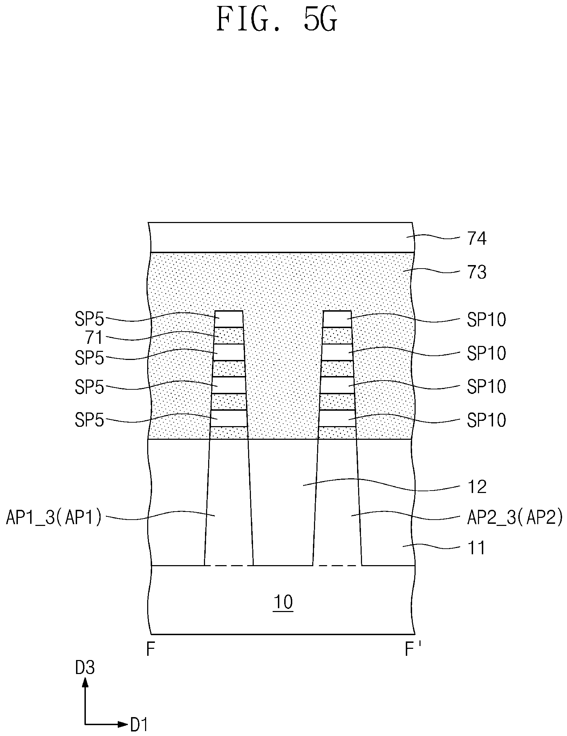

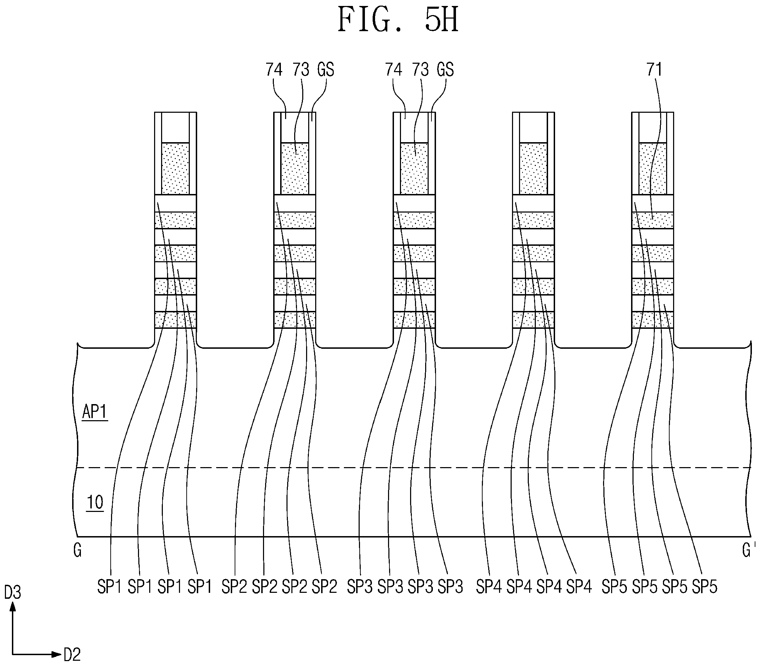

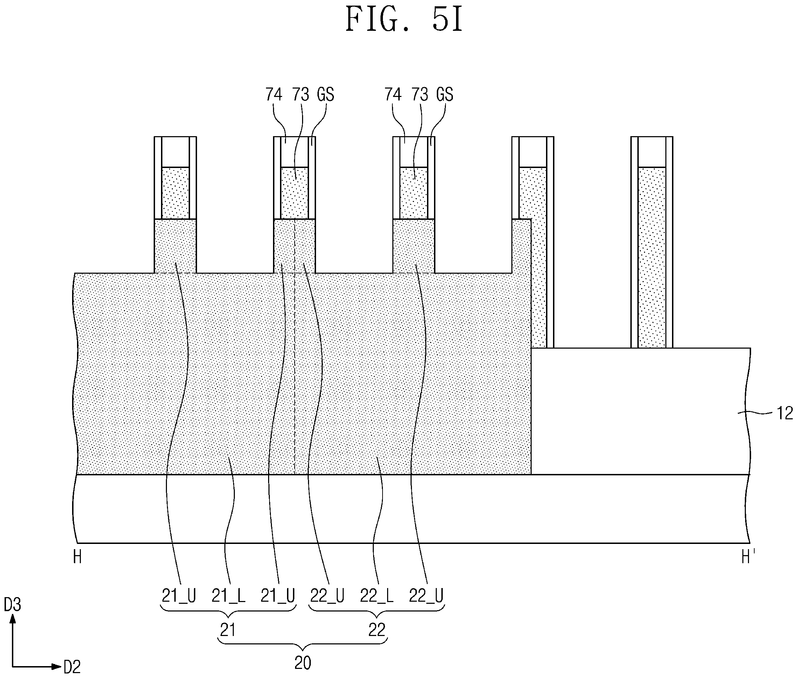

Referring to FIGS. 5A, 5B, 5C, 5D, 5E, 5F, 5G, 5H, and 5I, gate sacrificial patterns 73, gate mask patterns 74 and gate spacers GS may be formed. An operation of forming the gate sacrificial patterns 73, the gate mask patterns 74 and the gate spacers GS may include an operation of forming a preliminary gate sacrificial layer on the lower isolation insulating layer 20, the semiconductor layers 72 and the sacrificial semiconductor layers 71, an operation of forming the gate mask pattern 74 on the preliminary gate sacrificial layer, an operation of forming the gate sacrificial pattern 73 by etching the preliminary gate sacrificial layer by using the gate mask pattern 74 as an etching mask, and an operation of forming the gate spacers GS.

The gate sacrificial pattern 73 and the gate mask pattern 74 may extend in the first direction D1. For example, the gate sacrificial pattern 73 may include polysilicon. The gate mask pattern 74 may include an insulating material.

The lower isolation insulating layer 20, the sacrificial semiconductor layers 71, the semiconductor layers 72 and the active patterns AP1 and AP2 may be etched by using the gate mask pattern 74 and the gate spacer GS as etching masks. The semiconductor layer 72 may be etched to divide the semiconductor layer 72 into the semiconductor patterns SP1 to SP10.

Lower portions 21_L and 22_L and upper portions 21_U and 22_U of the first isolation portion 21 and the second isolation portion 22 may be formed by etching the lower isolation insulating layer 20.

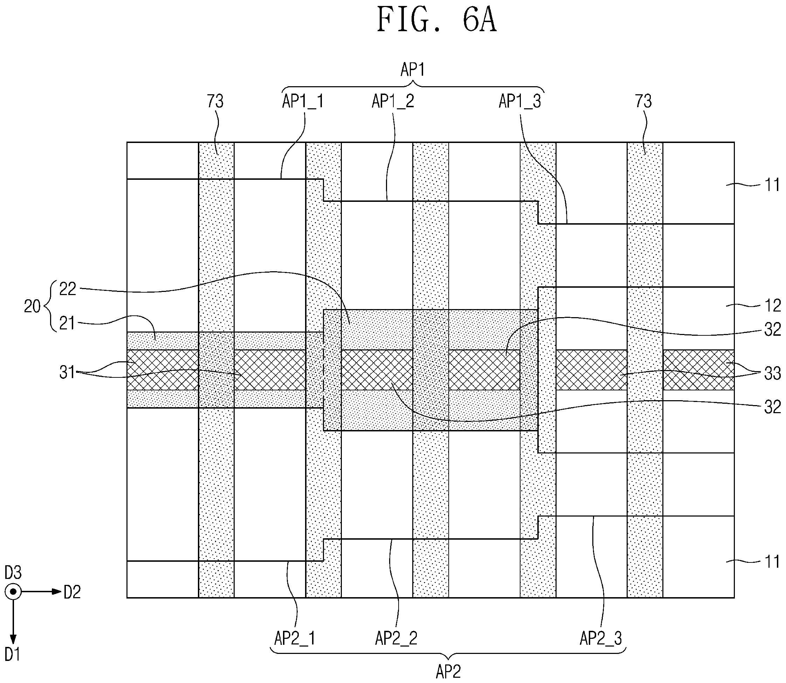

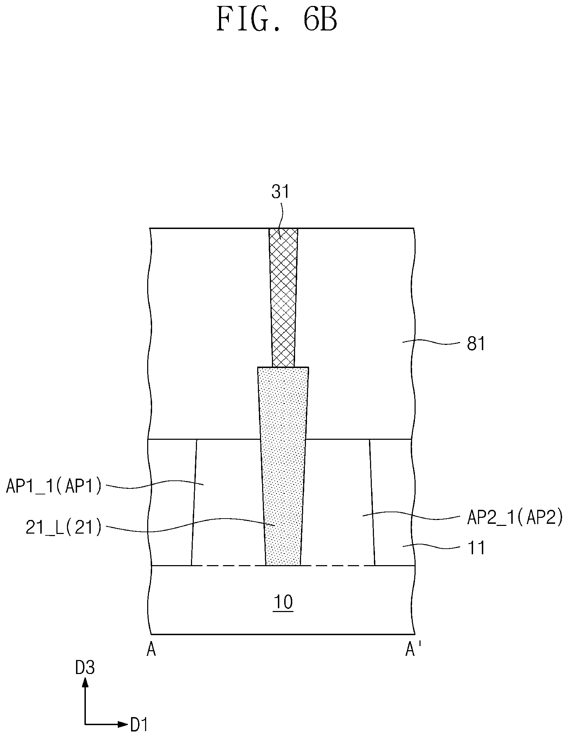

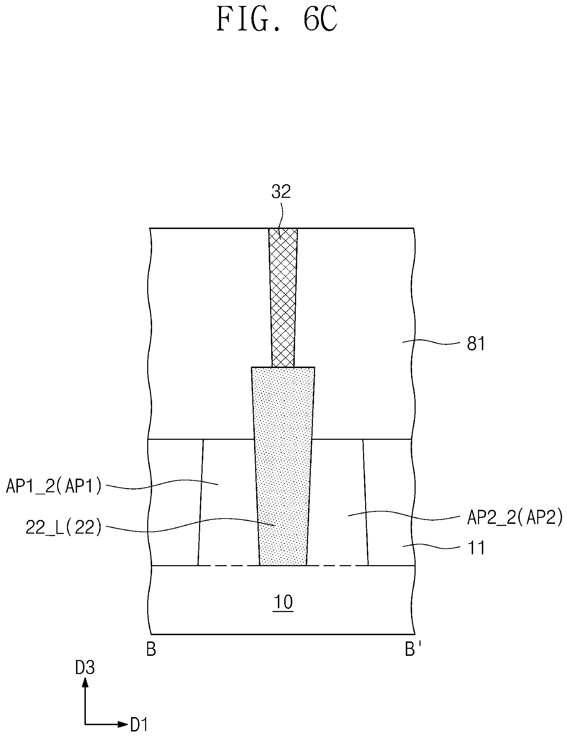

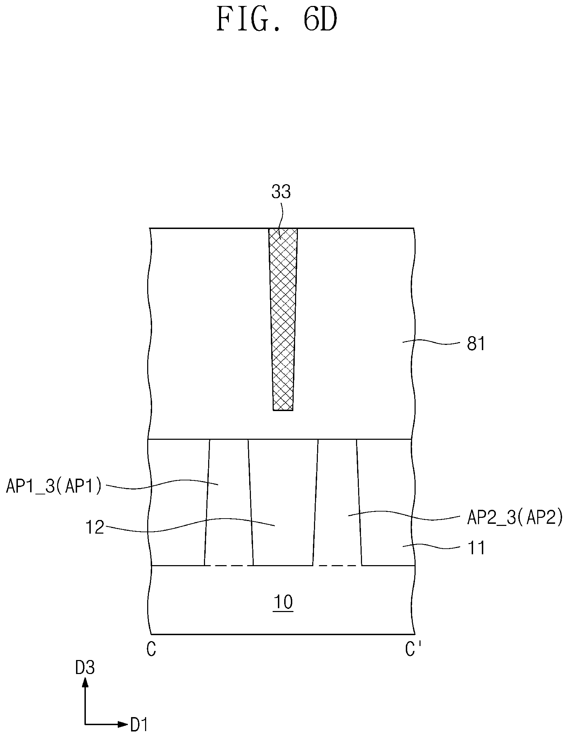

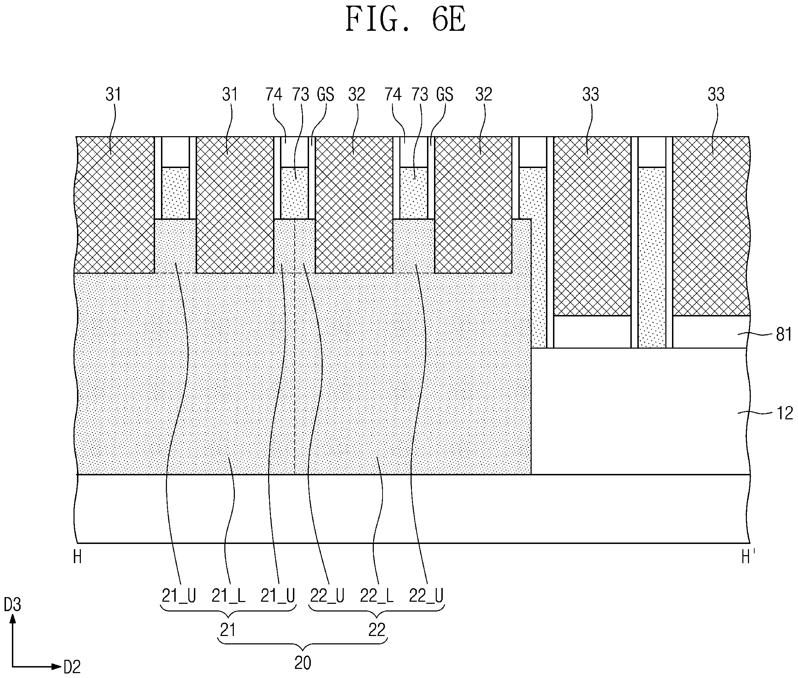

Referring to FIGS. 6A, 6B, 6C, 6D, and 6E, a support insulating layer 81 may be formed. The support insulating layer 81 may be formed on the lower isolation insulating layer 20 and the active patterns AP1 and AP2. The support insulating layer 81 may include an insulating material.

First to third upper isolation insulating layers 31, 32 and 33 may be formed. An operation of forming the first to third upper isolation insulating layers 31, 32 and 33 may include an operation of patterning the support insulating layer 81, and an operation of forming the first to third upper isolation insulating layers 31, 32 and 33 in an empty space formed by patterning the support insulating layer 81.

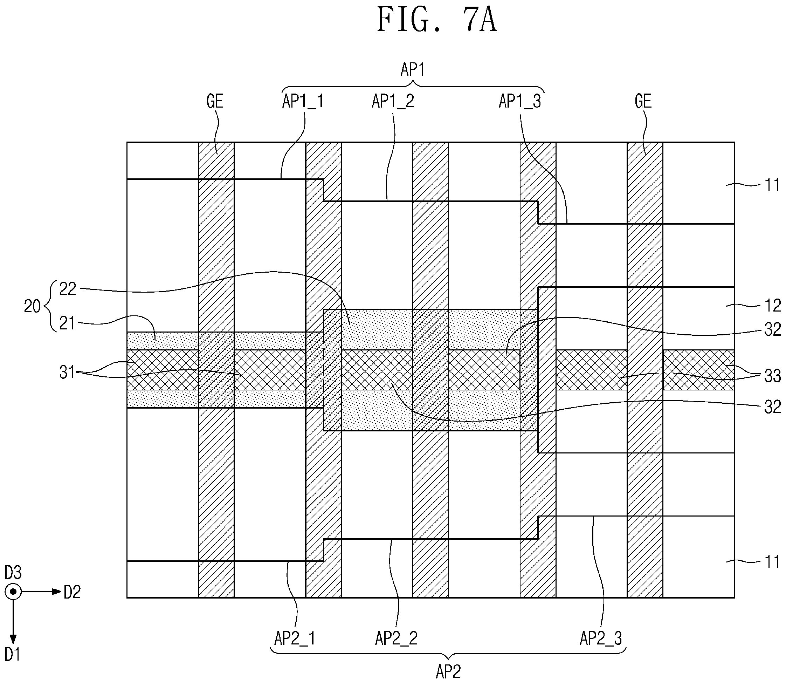

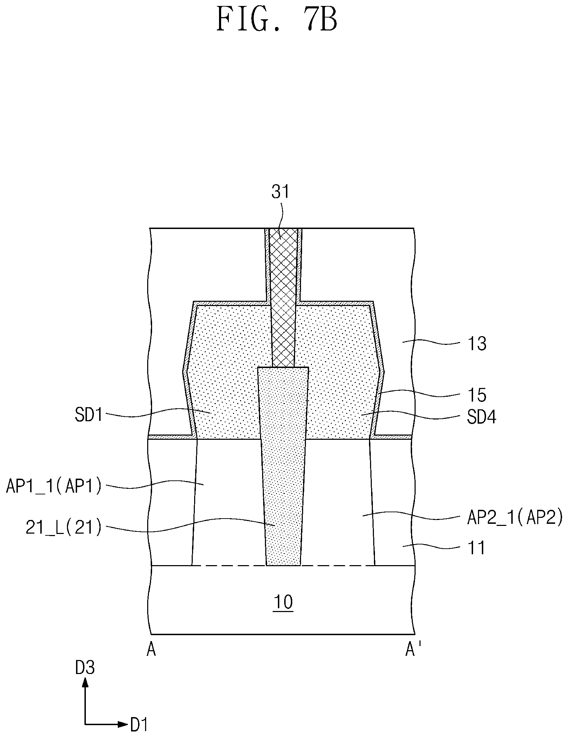

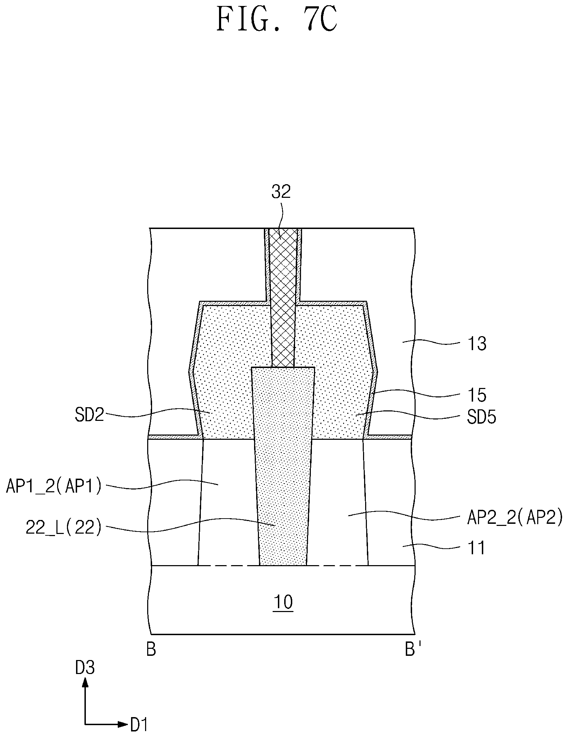

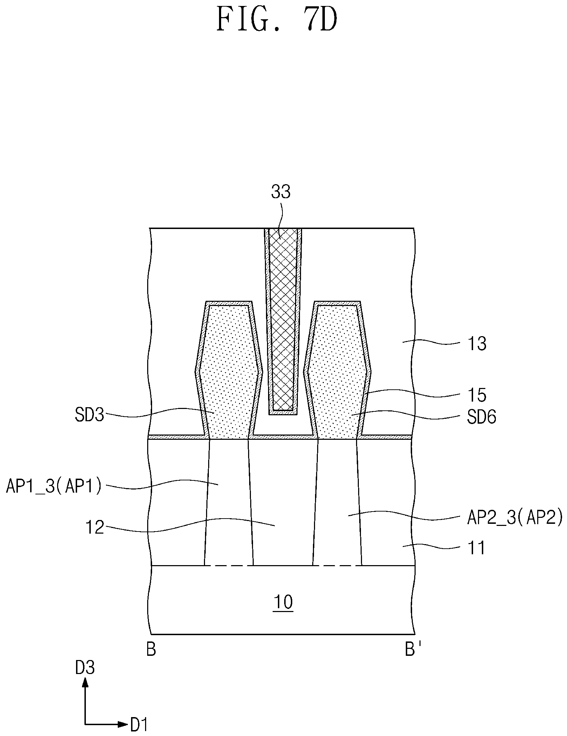

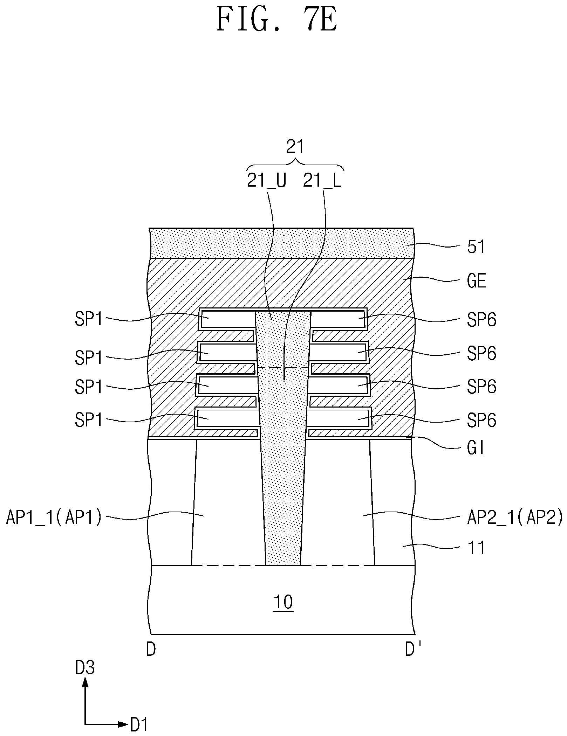

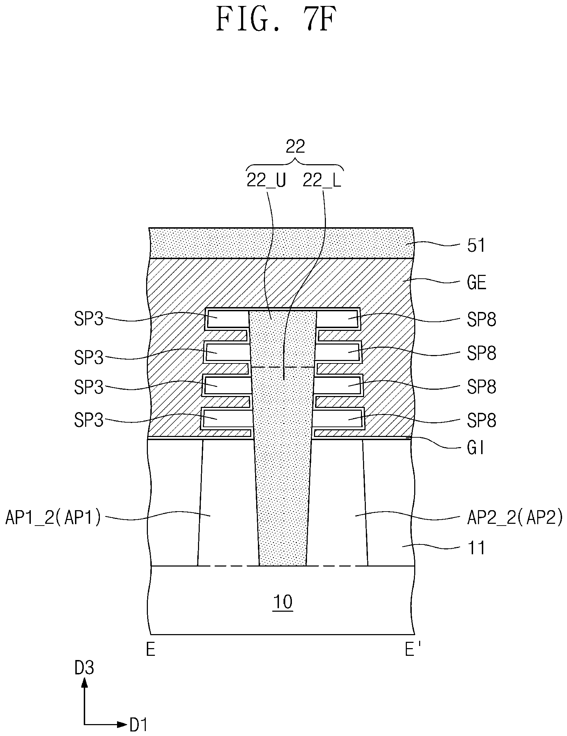

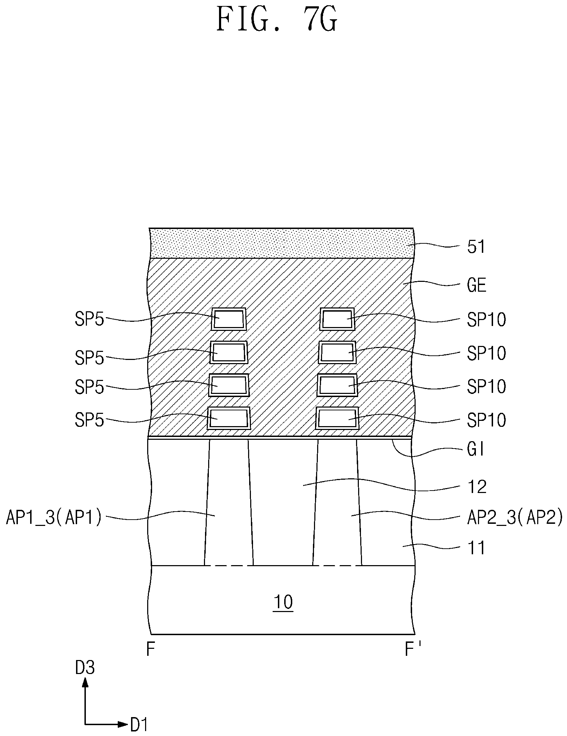

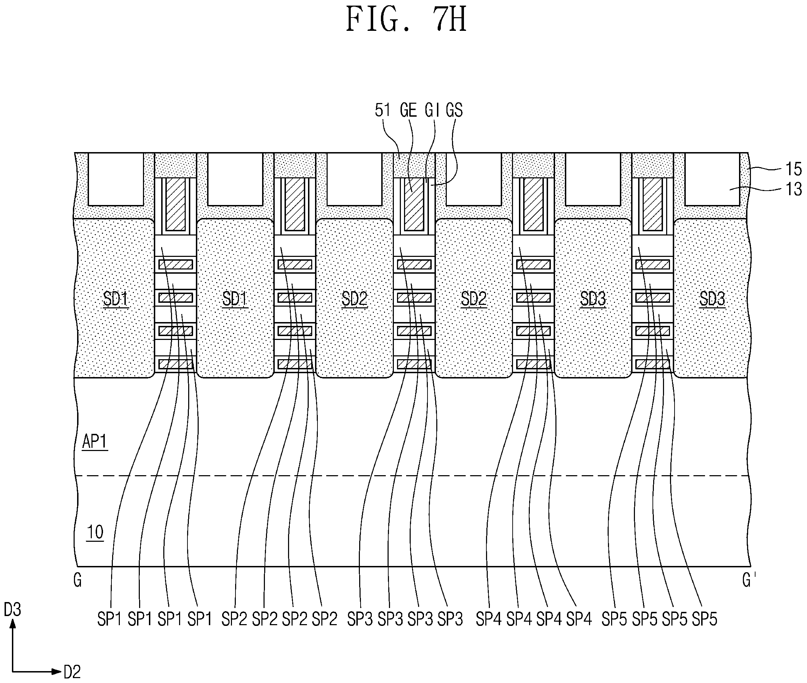

Referring to FIGS. 7A, 7B, 7C, 7D, 7E, 7F, 7G and 7H, the support insulating layer 81 may be removed. The support insulating layer 81 may be removed to expose the first and second active patterns AP1 and AP2.

Source/drain patterns SD1 to SD6 may be formed. The source/drain patterns SD1 to SD6 may be formed through a selective epitaxial growth process. A cover insulating layer 15 may be formed. An insulating layer 13 may be formed.

The gate mask pattern 74, the gate sacrificial pattern 73 and the sacrificial semiconductor layers 71 may be removed. A gate insulating layer GI and a gate electrode GE may be formed. The gate insulating layer GI and the gate electrode GE may be formed in empty spaces formed by removing the gate sacrificial pattern 73 and the sacrificial semiconductor layers 71. A capping insulating layer 51 may be formed on the gate electrode GE.

Referring to FIGS. 1A to 1I, upper active contacts UAC may be formed. A first gate cutting insulating layer 41 and a second gate cutting insulating layer 42 may be formed. An upper insulating layer 52 may be formed. First contacts 61 and second contacts 62 penetrating the upper insulating layer 52 may be formed.

Lower active contacts LAC penetrating the active patterns AP1 and AP2 may be formed.

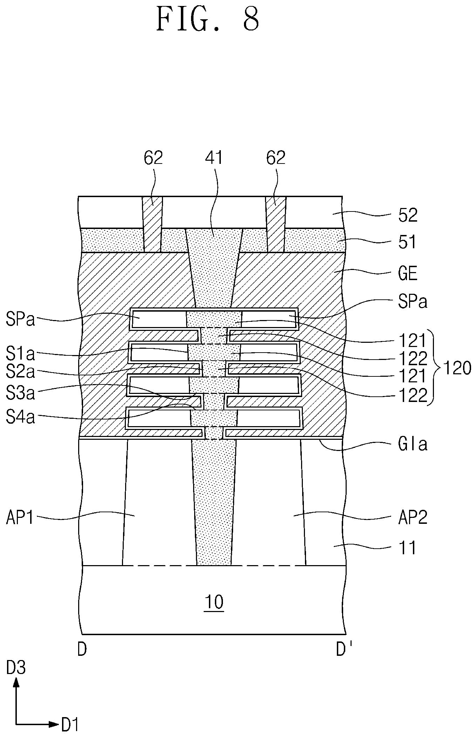

FIG. 8 is a cross-sectional view of a semiconductor device according to some embodiments. The semiconductor device according to FIG. 8 may be similar to a semiconductor device according to FIGS. 1A to 1I except for what is illustrated below.

Referring to FIG. 8, a lower isolation insulating layer 120 may include a first sidewall S1a in contact with a semiconductor pattern SPa, and a second sidewall S2a, a first connection surface S3a and a second connection surface S4a in contact with a gate insulating layer GIa.

Each of the first connection surface S3a and the second connection surface S4a may connect the first sidewall S1a and the second sidewall S2a. The first connection surface S3a and the second connection surface S4a may be parallel to the first direction D1 and the second direction D2. For example, the first connection surface S3a and the second connection surface S4a may be parallel to a horizontal direction.

A distance between the first sidewalls S1a, of the lower isolation insulating layer 120, opposed to each other may be greater than a distance between the second sidewalls S2a, of the lower isolation insulating layer 120, opposed to each other.

The lower isolation insulating layer 120 may include first parts 121 disposed at the same level as the semiconductor pattern SPa and second parts 122 between the first parts 121. A width of the first part 121 in the first direction D1 may be greater than a width of the second part 122 in the first direction D1.

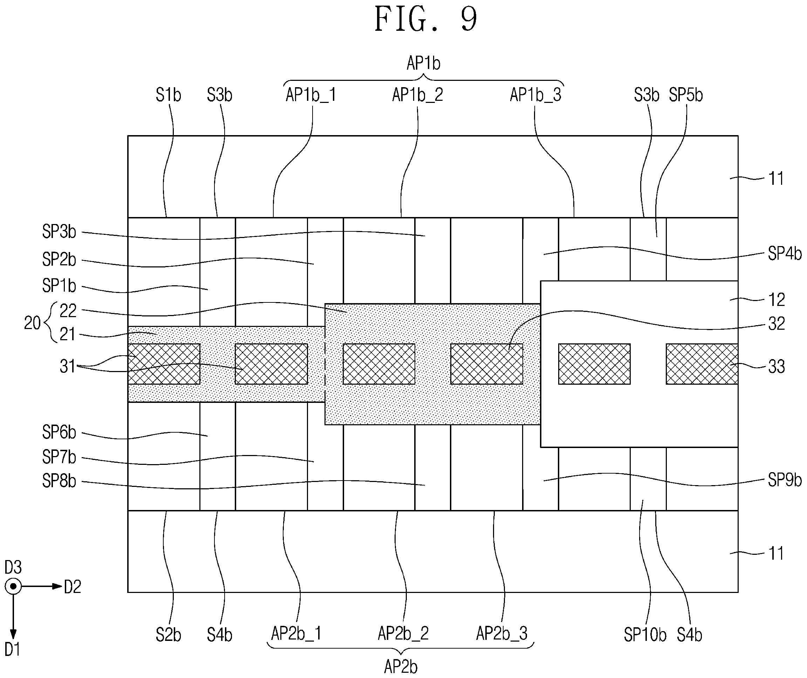

FIG. 9 is a plan view of a semiconductor device according to some embodiments. The semiconductor device according to FIG. 9 may be similar to a semiconductor device according to FIGS. 1A to 1I except for what is illustrated below.

Referring to FIG. 9, a first active pattern AP1b may include a first part AP1b_1, a second part AP1b_2 having a smaller width than the first part AP1b_1, and a third part AP1b_3 having a smaller width than the second part AP1b_2. A second active pattern AP2b may include a first part AP2b_1, a second part AP2b_2 having a smaller width than the first part AP2b_1, and a third part AP2b_3 having a smaller width than the second part AP2b_2.

The first to third parts AP1b_1, AP1b_2 and AP1b_3 of the first active pattern AP1b may include sidewalls S1b parallel to each other. The first to third parts AP1b_1, AP1b_2 and AP1b_3 of the first active pattern AP1b may be coplanar with the sidewalls S1b. The sidewalls S1b of the first to third parts AP1b_1, AP1b_2 and AP1b_3 of the first active pattern AP1b may be disposed on a straight line extending in the second direction D2.

The first to third parts AP2b_1, AP2b_2 and AP2b_3 of the second active pattern AP2b may include sidewalls S2b parallel to each other. The first to third parts AP2b_1, AP2b_2 and AP2b_3 of the second active pattern AP2b may be coplanar with the sidewalls S2b. The sidewalls S2b of the first to third parts AP2b_1, AP2b_2 and AP2b_3 of the second active pattern AP2b may be disposed on a straight line extending in the second direction D2.

First to fifth semiconductor patterns SP1b to SP5b may include sidewalls S3b parallel to each other. The sidewalls S3b of the first to fifth semiconductor patterns SP1b to SP5b may be disposed on a straight line extending in the second direction D2.

Sixth to tenth semiconductor patterns SP6b to SP10b may include sidewalls S4b parallel to each other. The sidewalls S4b of the sixth to tenth semiconductor patterns SP6b to SP10b may be disposed on a straight line extending in the second direction D2.

A distance between the first semiconductor pattern SP1b and the sixth semiconductor pattern SP6b in the first direction D1 may be smaller than a distance between the third semiconductor pattern SP3b and the eighth semiconductor pattern SP8b in the first direction D1. A distance between the third semiconductor pattern SP3b and the eighth semiconductor pattern SP8b in the first direction D1 may be smaller than a distance between the fifth semiconductor pattern SP5b and the tenth semiconductor pattern SPlOb in the first direction D1.

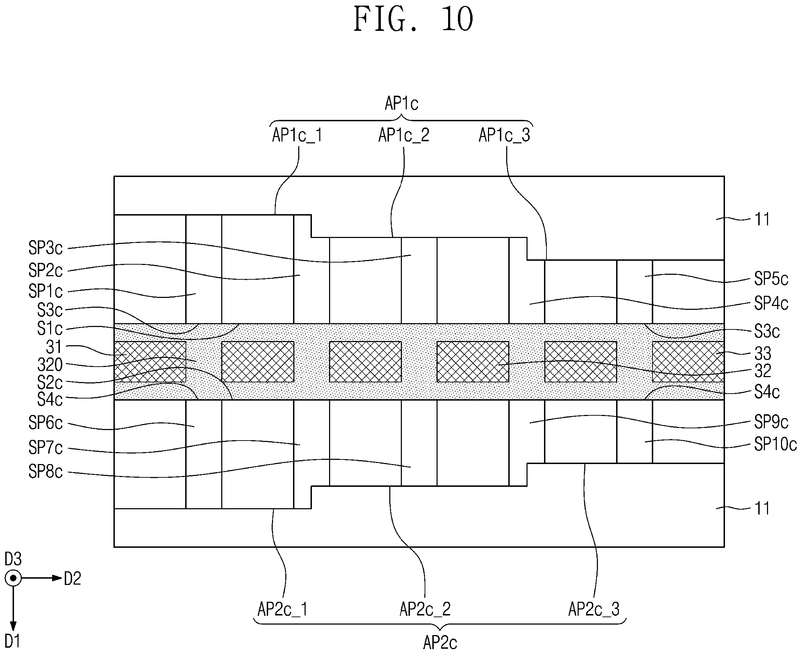

FIG. 10 is a plan view of a semiconductor device according to embodiments. The semiconductor device according to FIG. 10 may be similar to a semiconductor device according to FIGS. 1A to 1I except for what is illustrated below.

Referring to FIG. 10, a first active pattern AP1c may include a first part AP1c_1, a second part AP1c_2 having a smaller width than the first part AP1c_1, and a third part AP1c_3 having a smaller width than the second part AP1c_2. A second active pattern AP2c may include a first part AP2c_1, a second part AP2c_2 having a smaller width than the first part AP2c_1, and a third part AP2c_3 having a smaller width than the second part AP2c_2.

The first to third parts AP1c_1, AP1c_2 and AP1c_3 of the first active pattern AP1c may include sidewalls S1c parallel to each other. The first to third parts AP1c_1, AP1c_2 and AP1c_3 of the first active pattern AP1c may be coplanar with the sidewalls S1c. The sidewalls S1c of the first to third parts AP1c_1, AP1c_2 and AP1c_3 of the first active pattern AP1c may be in contact with a lower isolation insulating layer 320.

The first to third parts AP2c_1, AP2c_2 and AP2c_3 of the second active pattern AP2c may include sidewalls S2c parallel to each other. The first to third parts AP2c _1, AP2c_2 and AP2c_3 of the second active pattern AP2c may be coplanar with the sidewalls S2c. The sidewalls S2c of the first to third parts AP2c _1, AP2c_2 and AP2c_3 of the first active pattern AP2c may be in contact with the lower isolation insulating layer 320.

In a plan view according to FIG. 10, a width of the lower isolation insulating layer 320 in the first direction D1 may be constant. First to third upper isolation insulating layers 31, 32 and 33 may be in contact with the lower isolation insulating layer 320.

First to fifth semiconductor patterns SP1c to SP5c may include sidewalls S3c parallel to each other. The sidewalls S3c of the first to fifth semiconductor patterns SP1c to SP5c may be disposed on a straight line extending in the second direction D2.

Sixth to tenth semiconductor patterns SP6c to SP10c may include sidewalls S4c parallel to each other. The sidewalls S4c of the sixth to tenth semiconductor patterns SP6c to SP10c may be disposed on a straight line extending in the second direction D2.

A distance between the first semiconductor pattern SP1c and the sixth semiconductor pattern SP6c in the first direction D1, a distance between the third semiconductor pattern SP3c and the eighth semiconductor pattern SP8c in the first direction D1, and a distance between the fifth semiconductor pattern SP5c and the tenth semiconductor pattern SP10c in the first direction D1 may be the same as each other.

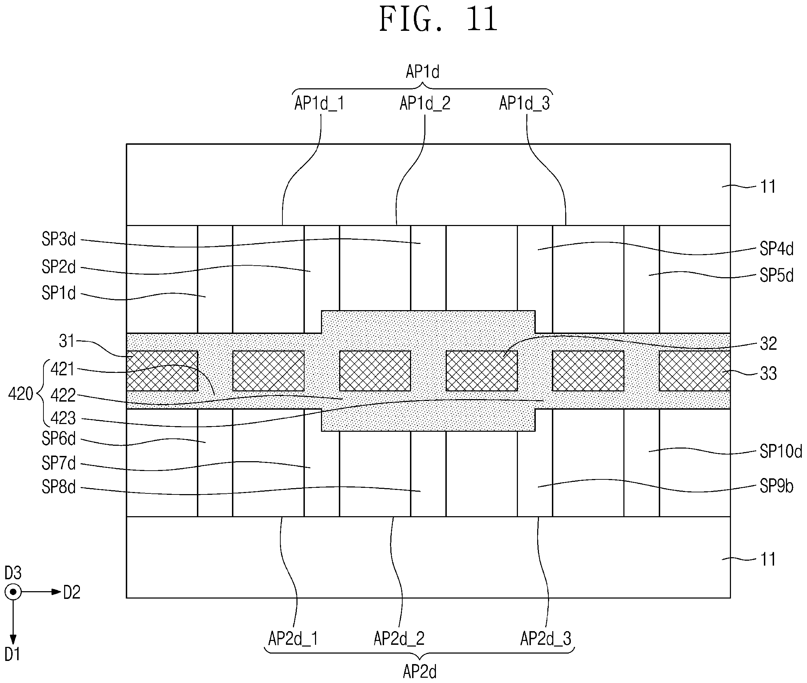

FIG. 11 is a plan view of a semiconductor device according to embodiments. The semiconductor device according to FIG. 11 may be similar to a semiconductor device according to FIGS. 1A to 1I except for what is illustrated below.

Referring to FIG. 11, a first active pattern AP1d may include a first part AP1d_1, a second part AP1d_2 having a smaller width than the first part AP1d_1, and a third part AP1d_3 having the same width as the first part AP1d_1. A second active pattern AP2d may include a first part AP2d _1, a second part AP2b_2 having a smaller width than the first part AP2d_1, and a third part AP2d_3 having the same width as the first part AP2b _1.

A lower isolation insulating layer 420 may include a first isolation portion 421 between the first parts AP1d_1 and AP2d_1 of the first and second active patterns AP1d and AP2d, a second isolation portion 422 between the second parts AP1d_2 and AP2d_2 of the first and second active patterns AP1d and AP2d, and a third isolation portion 423 between the third parts AP1d_3 and AP2d_3 of the first and second active patterns AP1d and AP2d.

In a plan view according to FIG. 11, a width of the first isolation portion 421 in the first direction D1 may be the same as a width of the third isolation portion 423 in the first direction D1. A width of the second isolation portion 422 in the first direction D1 may be larger than a width of the first isolation portion 421 in the first direction D1.

First to fifth semiconductor patterns SP1d to SP5d overlapping the first active pattern AP1d may be provided. Widths of the first and fifth semiconductor patterns SP1d and SP5d in the first direction D1 may be the same as each other. A width of the third semiconductor pattern SP3d in the first direction D1 may be smaller than a width of the first semiconductor pattern SP1d in the first direction D1.

Sixth to tenth semiconductor patterns SP6d to SP10d overlapping the second active pattern AP2d may be provided. Widths of the sixth and tenth semiconductor patterns SP6d and SPlOd in the first direction D1 may be the same as each other. A width of the eighth semiconductor pattern SP8d in the first direction D1 may be smaller than a width of the sixth semiconductor pattern SP6d in the first direction D1.

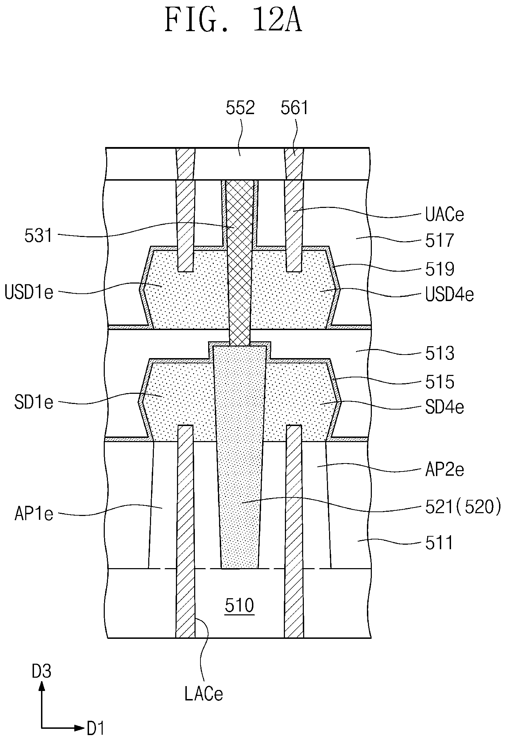

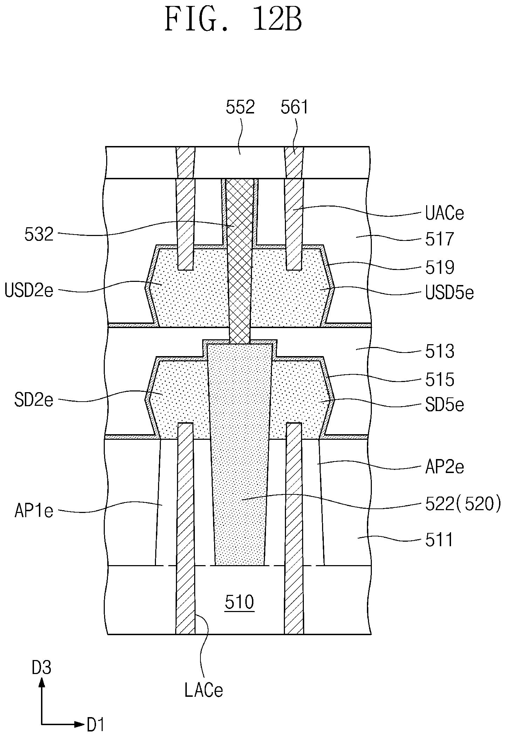

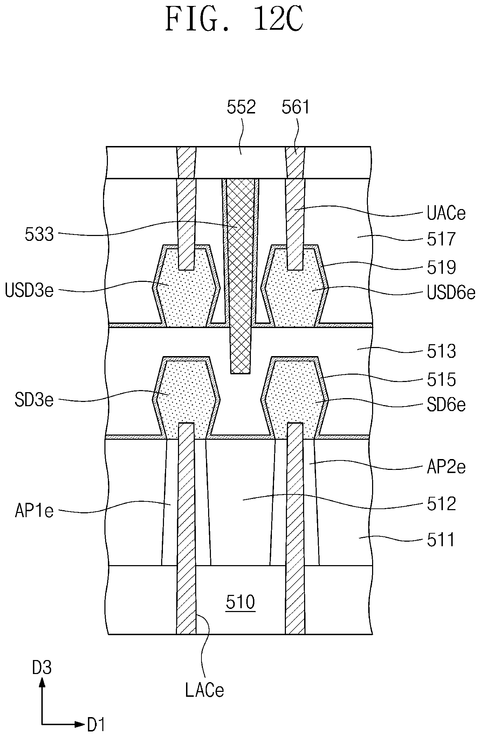

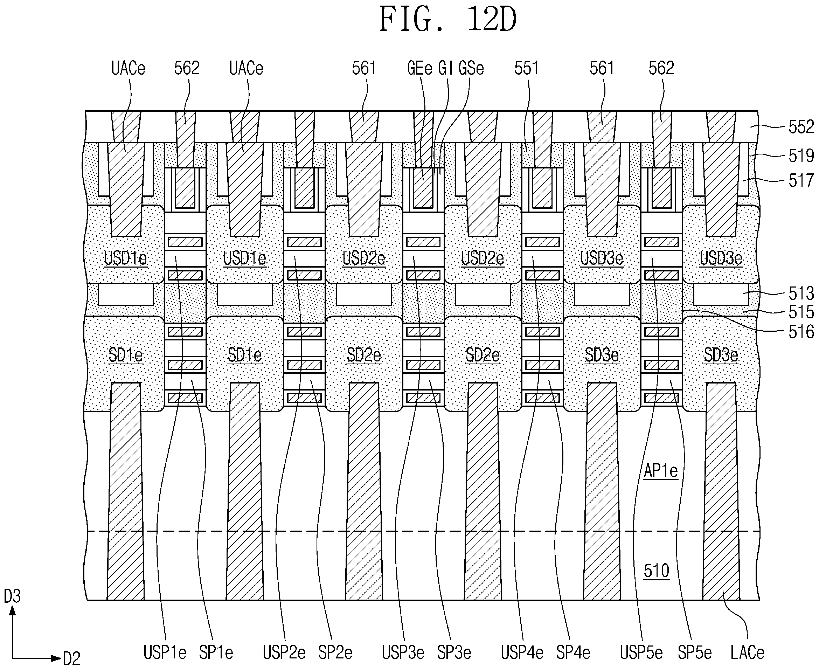

FIGS. 12A, 12B, 12C, and 12D are cross-sectional views of a semiconductor device according to some embodiments. The semiconductor device according to FIGS. 12A, 12B, 12C 12D may be similar to a semiconductor device according to FIGS. 1A to 1I except for what is illustrated below.

Referring to FIGS. 12A to 12D, the semiconductor device may include a substrate 510. The substrate 510 may include a first active pattern AP1e and a second active pattern AP2e.

First element isolation layers 511 may be provided on the substrate 510. The first and second active patterns AP1e and AP2e may be disposed between the first element isolation layers 511 spaced apart from each other in the first direction D1. A second element isolation layer 512 may be provided on the substrate 510. The second element isolation layer 512 may be disposed between the first and second active patterns AP1e and AP2e.

Semiconductor patterns SP1e to SP5e and upper semiconductor patterns USP1e to USP5e overlapping first and second active patterns AP1e and AP2e in the third direction D3 may be provided. The semiconductor patterns SP1e to SP5e may include first to fifth semiconductor patterns SP1e to SP5e overlapping the first active pattern AP1e in the third direction D3. The upper semiconductor patterns USP1e to USP5e may include first to fifth upper semiconductor patterns USP1e to USP5e overlapping the first active pattern AP1e in the third direction D3. The first semiconductor patterns SP1e and the first upper semiconductor patterns USP1e may overlap each other in the third direction D3.

Interposition insulating patterns 516 may be provided. The interposition insulating pattern 516 may be disposed between the semiconductor patterns SP1e to SP5e and the upper semiconductor patterns USP1e to USP5e. The interposition insulating pattern 516 may include an insulating material.

An upper surface and a lower surface of the interposition insulating pattern 516 may be in contact with a gate insulating layer GIe. According to some embodiments, the upper surface of the interposition insulating pattern 516 may be in contact with the upper semiconductor patterns USP1e to USP5e, and the lower surface of the interposition insulating pattern 516 may be in contact with the semiconductor patterns SP1e to SP5e.

First source/drain patterns SD1e, second source/drain patterns SD2e, and third source/drain patterns SD3e may be provided on the first active pattern AP1e. Fourth source/drain patterns SD4e, fifth source/drain patterns SD5e, and sixth source/drain patterns SD6e may be provided on the second active pattern AP2e.

A first upper source/drain pattern USD1e overlapping a first source/drain pattern SD1e in the third direction D3, a second upper source/drain pattern USD2e overlapping a second source/drain pattern SD2e in the third direction D3, a third upper source/drain pattern USD3e overlapping a third source/drain pattern SD3e in the third direction D3, a fourth upper source/drain pattern USD4e overlapping a fourth source/drain pattern SD4e in the third direction D3, a fifth upper source/drain pattern USD5e overlapping a fifth source/drain pattern SD5e in the third direction D3, and a upper sixth source/drain pattern USD6e overlapping a sixth source/drain pattern SD6e in the third direction D3 may be provided. The upper source/drain patterns USD1e to USD6e may be each an epitaxial pattern formed in a selective epitaxial growth process. The first upper source/drain pattern SD1e may be in contact with the first upper semiconductor patterns USP1e.

A lower isolation insulating layer 520 may be provided. The lower isolation insulating layer 520 may be disposed between the first and fourth source/drain patterns SD1e and SD4e and the second and fifth source/drain patterns SD2e and SD5e.

A width of the first semiconductor pattern SP1e in the first direction D1 may be greater than a width of the third semiconductor pattern SP3e in the first direction D1. The width of the third semiconductor pattern SP3e in the first direction D1 may be greater than a width of the fifth semiconductor pattern SP5e in the first direction D1. A width of the first upper semiconductor pattern USP1e in the first direction D1 may be greater than a width of the third upper semiconductor pattern USP3e in the first direction D1. The width of the third upper semiconductor pattern USP3e in the first direction D1 may be greater than a width of the fifth upper semiconductor pattern USP5e in the first direction D1.

A maximum width of the first source/drain pattern SD1e in the first direction D1 may be greater than a maximum width of the second source/drain pattern SD2e in the first direction D1. The maximum width of the second source/drain pattern SD2e in the first direction D1 may be greater than a maximum width of the third source/drain pattern SD3e in the first direction D1.

A maximum width of the first upper source/drain pattern USD1e in the first direction D1 may be greater than a maximum width of the second upper source/drain pattern USD2e in the first direction D1. The maximum width of the second upper source/drain pattern USD2e in the first direction D1 may be greater than a maximum width of the third upper source/drain pattern USD3e in the first direction D1.

The lower isolation insulating layer 520 may include a first isolation portion 521 between the first and fourth source/drain patterns SD1e and SD4e and a second isolation portion 522 between the second and fifth source/drain patterns SD2e and SD5e.

First upper isolation insulating layers 531, second upper isolation insulating layers 532 and third upper isolation insulating layers 533 may be provided. The first upper isolation insulating layers 531 may be provided on the first isolation portion 521. The first upper isolation insulating layer 531 may be disposed between the first and fourth upper source/drain patterns USD1e and USD4e. The second upper isolation insulating layers 532 may be provided on the second isolation portion 522. The second upper isolation insulating layer 532 may be disposed between the second and fifth source/drain patterns USD2e and USD5e. The third upper isolation insulating layers 533 may be spaced apart from the lower isolation insulating layer 520. The third upper isolation insulating layer 533 may be disposed between the third and sixth upper source/drain patterns USD3e and USD6e.

Gate electrodes GEe may be provided. The gate electrode GEe may overlap the semiconductor patterns SP1e to SP5e and the upper semiconductor patterns USP1e to USP5e in the third direction D3.

Gate insulating layers GIe may be provided. The gate electrode GEe may be spaced apart from the semiconductor patterns SP1e to SP5e and the upper semiconductor patterns USP1e to USP5e by the gate insulating layer GIe. Gate spacers GSe may be provided. The gate spacers GSe may be disposed on both sides of the gate electrode GEe.

A first cover insulating layer 515 may be provided. The first cover insulating layer 515 may cover the source/drain patterns SD1e to SD6e. A first insulating layer 513 may be provided on the first cover insulating layer 515. The first to sixth upper source/drain patterns USP1e to USD6e may be provided on the first insulating layer 513.

A second cover insulating layer 519 may be provided. The second cover insulating layer 519 may cover the upper source/drain patterns USD1e to USD6e. A second insulating layer 517 may be provided on the second cover insulating layer 519.

Upper active contacts UACe may be provided. The upper active contact UACe may be in contact the upper source/drain patterns USD1e to USD6e. Lower active contacts LACe may be provided. The lower active contact LACe may be in contact the source/drain patterns SD1e to SD6e.

A capping insulating layer 551 may be provided. An upper insulating layer 552 may be provided on the capping insulating layer 551.

First contacts 561 may be provided. The first contact 561 may penetrate the upper insulating layer 552 to be in contact with the upper active contact UACe. Second contacts 562 may be provided. The second contact 562 may penetrate the upper insulating layer 552 and the capping insulating layer 551 to be in contact with the gate electrode GEe.

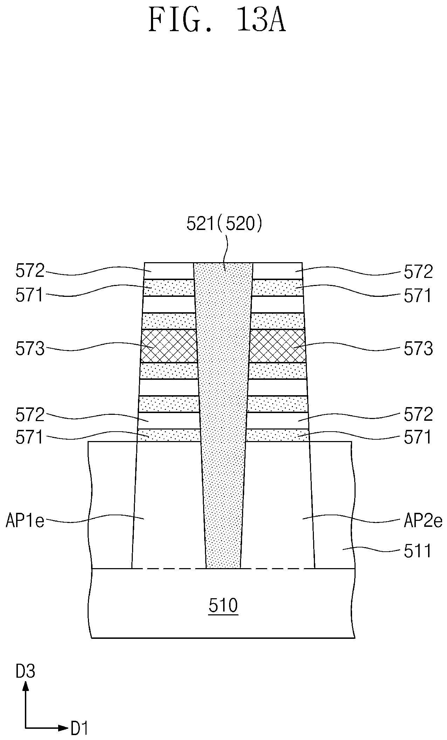

FIGS. 13A, 13B, 13C, 13D, 14A, 14B, 14C, 14D, 15A, 15B, 15C and 15D are cross-sectional views for describing a method for manufacturing a semiconductor device according to some embodiments.

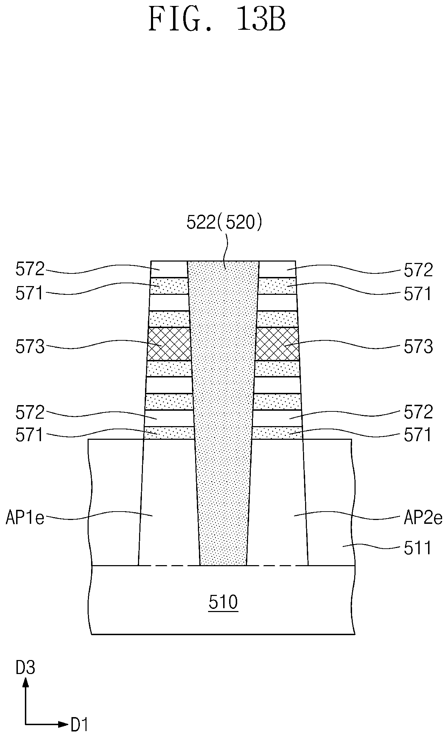

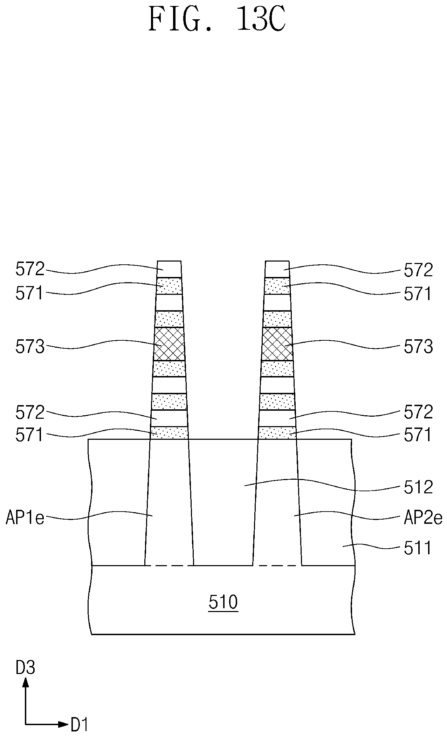

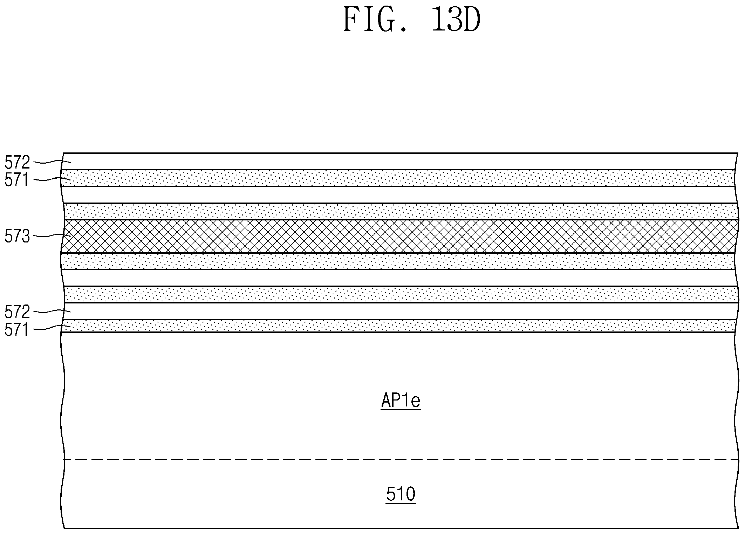

Referring to FIGS. 13A, 13B, 13C, and 13D, a first element isolation layer 511, first and second active patterns AP1e and AP2e, first sacrificial semiconductor layers 571, and second sacrificial semiconductor layers 573 and semiconductor layers 572 may be formed.

An upper surface and a lower surface of the second sacrificial semiconductor layer 573 may be in contact with the first sacrificial semiconductor layer 571. According to some embodiments, the upper surface and the lower surface of the second sacrificial semiconductor layer 573 may be in contact with the semiconductor layer 572.

The second sacrificial semiconductor layer 573 may include a material having etching selectivity for the first sacrificial semiconductor layer 571. For example, the second sacrificial semiconductor layer 573 and the first sacrificial semiconductor layer 571 may include silicon-germanium (SiGe), and the second sacrificial semiconductor layer 573 may have a greater germanium concentration than the first sacrificial semiconductor layer 571.

A lower isolation insulating layer 520 may be provided. A second element isolation layer 512 may be formed.

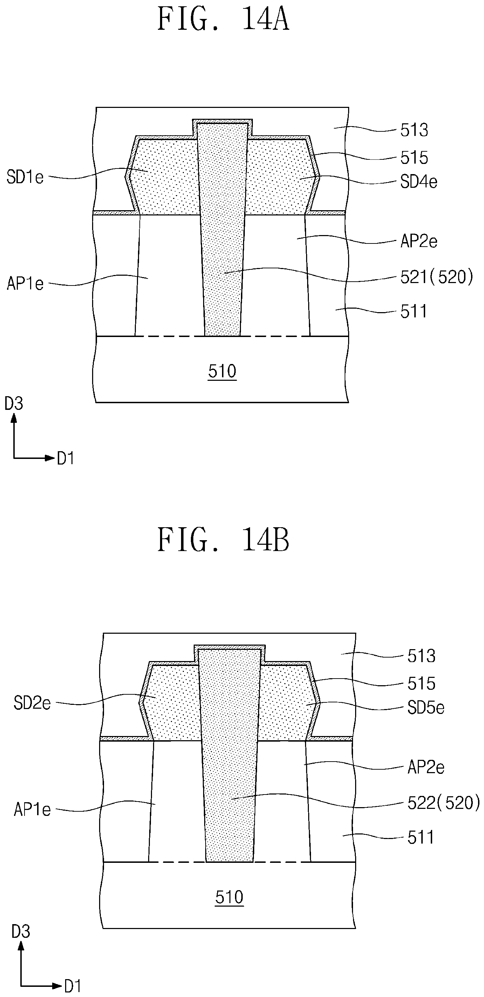

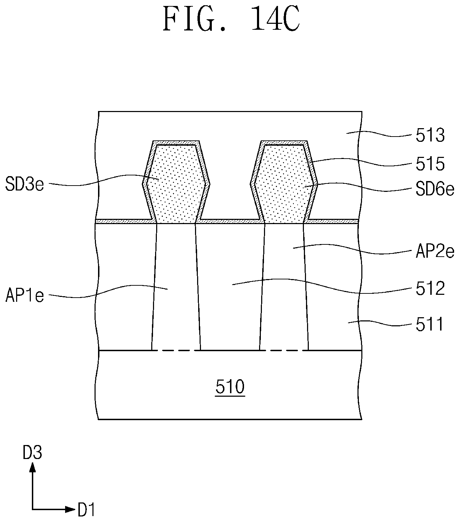

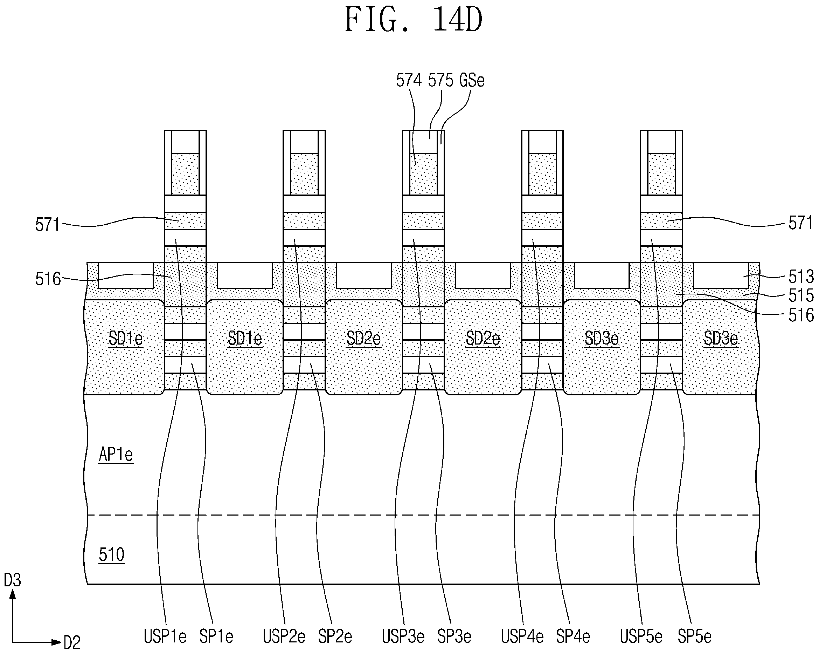

Referring to FIGS. 14A, 14B, 14C, and 14D, gate sacrificial patterns 574, gate mask patterns 575 and gate spacers GSe may be formed.

The lower isolation insulating layer 520, the first sacrificial semiconductor layers 571, the second sacrificial semiconductor layers 573, the semiconductor layers 572 and the active patterns AP1e and AP2e may be etched by using the gate mask pattern 575 and the gate spacer GSe as etching masks. The semiconductor layer 572 may be etched to divide the semiconductor layer 572 into the semiconductor patterns SP1e to SP5e and the upper semiconductor patterns USP1e to USP5e.

The second sacrificial semiconductor pattern 573 may be substituted with the interposition insulating pattern 516. According to some embodiments, the second sacrificial semiconductor layer 573 may be oxidized to form the interposition insulating layer 516. According to some embodiments, after removing the second sacrificial semiconductor layer 573, the interposition insulating pattern 516 be formed.

Source/drain patterns SD1e to SD6e may be formed. A first cover insulating layer 515 may be formed. A first insulating layer 513 may be formed.

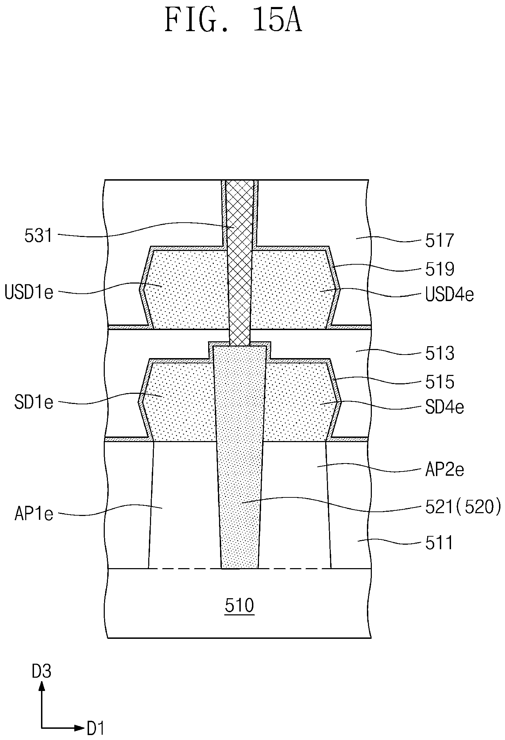

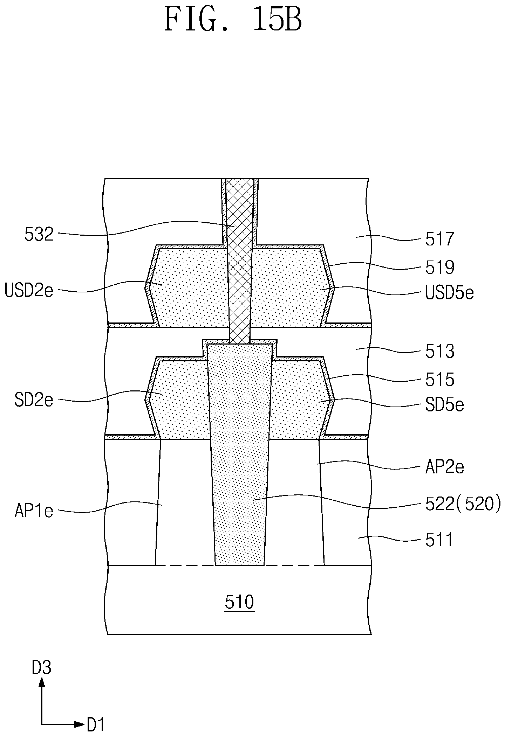

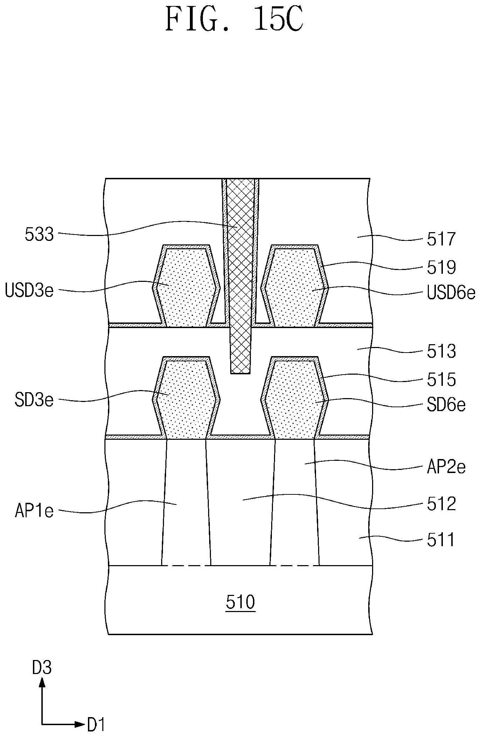

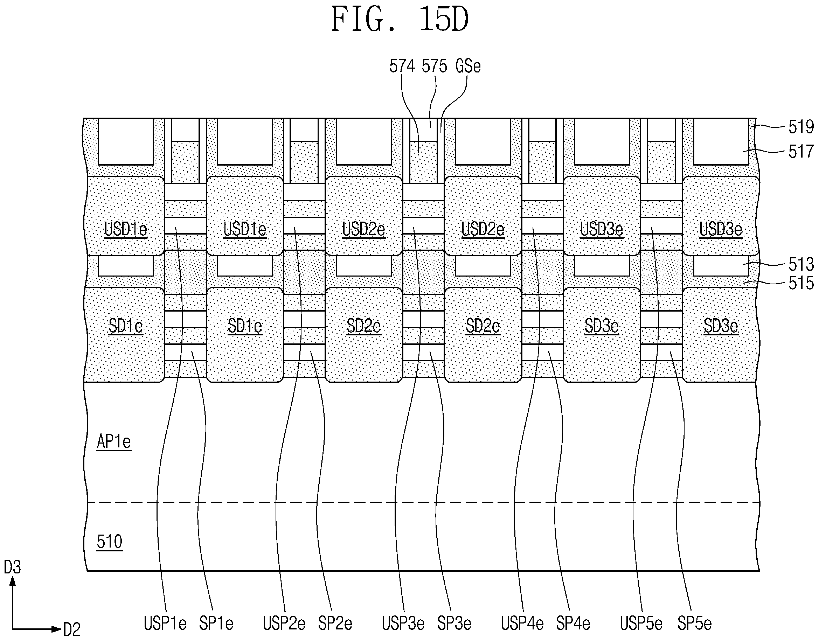

Referring to FIGS. 15A, 15B, 15C, and 15D, first to third upper isolation insulating layers 531, 532 and 533 may be formed. An operation of forming the first to third upper isolation insulating layers 531, 532 and 533 may include an operation of forming a support insulating layer on the first insulating layer 513, an operation of forming the first to third upper isolation insulating layers 531, 532 and 533 penetrating the support insulating layer, and an operation of removing the support insulating layer.

Upper source/drain patterns USD1e to USD6e may be formed. The upper source/drain patterns USD1e to USD6e may be formed through an epitaxial growth process by using upper semiconductor patterns USP1e to USP6e as seeds.

A second cover insulating layer 519 covering the upper source/drain patterns USD1e to USD6e may be formed. A second insulating layer 517 may be formed on the second cover insulating layer 519.

Referring to FIGS. 12A, 12B, 12C, and 12D, the gate sacrificial pattern 574, the gate mask pattern 575 and the sacrificial semiconductor layers 571 may be removed. A gate insulating layer GIe and a gate electrode GEe may be formed. A capping insulating layer 551 may be formed.

Upper active contacts UACe may be formed. An upper insulating layer 552 may be formed. First contacts 561 and second contacts 562 penetrating the upper insulating layer 552 may be formed. Lower active contacts LACe may be formed.

Since a semiconductor device according to embodiments of the inventive concept includes semiconductor patterns having different widths, a degree of freedom in designing the semiconductor device may be improved.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

Embodiments are set out in the following Clauses:
Clause 1. A semiconductor device comprising:
   a first active pattern and a second active pattern spaced apart from each other in a first direction;
   a first semiconductor pattern and a second semiconductor pattern overlapping the first active pattern;
   a third semiconductor pattern and a fourth semiconductor pattern overlapping the second active pattern;
   a lower isolation insulating layer between the first and second active patterns;
   source/drain patterns on the first and second active patterns; and
   a gate electrode extending in the first direction,
   wherein the first and third semiconductor patterns are arranged in the first direction,
   the second and fourth semiconductor patterns are arranged in the first direction,
   a width of the first semiconductor pattern in the first direction is greater than a width of the second semiconductor pattern in the first direction,
   a width of the third semiconductor pattern in the first direction is greater than a width of the fourth semiconductor pattern in the first direction, and
   a sidewall of the first semiconductor pattern and a sidewall of the third semiconductor pattern are in contact with the lower isolation insulating layer.
Clause 2. The semiconductor device of Clause 1, wherein a minimum width of the first semiconductor pattern in the first direction is greater than a minimum width of the second semiconductor pattern in the first direction, and
   a minimum width of the third semiconductor pattern in the first direction is greater than a minimum width of the fourth semiconductor pattern in the first direction.
Clause 3. The semiconductor device of Clause 1 or Clause 2, wherein the lower isolation insulating layer comprises:
   a first isolation part between the first and third semiconductor patterns; and
   a second isolation part between the second and fourth semiconductor patterns, and
   a width of the first isolation part in the first direction is smaller than a width of the second isolation part in the first direction.
Clause 4. The semiconductor device of Clause 3, wherein the sidewall of the first semiconductor pattern and the sidewall of the third semiconductor pattern are in contact with the first isolation part, and
   a sidewall of the second semiconductor pattern and a sidewall of the fourth semiconductor pattern are in contact with the second isolation part.
Clause 5. The semiconductor device of Clause 3 or Clause 4, wherein the first isolation part comprises a lower portion and an upper portion,
   the second isolation part comprises a lower portion and an upper portion,
   the source/drain patterns comprise:
      a first source/drain pattern and a second source/drain pattern in contact with an upper surface of the lower portion of the first isolation part; and
      a third source/drain pattern and a fourth source/drain pattern in contact with an upper surface of the lower portion of the second isolation part, and
   a maximum width of each of the first and second source/drain patterns in the first direction is greater than a maximum width of each of the third and fourth source/drain patterns in the first direction.
Clause 6. The semiconductor device of Clause 5, further comprising:
   a first upper isolation insulating layer on the lower portion of the first isolation part; and
   a second upper isolation insulating layer on the lower portion of the second isolation part,
   wherein the first and second source/drain patterns are in contact with the first upper isolation insulating layer, and
   the third and fourth source/drain patterns are in contact with the second upper isolation insulating layer.
Clause 7. The semiconductor device of any preceding Clause, wherein the second and fourth semiconductor patterns are spaced apart from the lower isolation insulating layer.
Clause 8. The semiconductor device of any of Clauses 1-6, wherein a sidewall of the second semiconductor pattern and a sidewall of the fourth semiconductor pattern are in contact with the lower isolation insulating layer.
Clause 9. A semiconductor device comprising:
   a first active pattern and a second active pattern spaced apart from each other in a first direction;
   a first source/drain pattern and a second source/drain pattern on the first active pattern;
   a third source/drain pattern and a fourth source/drain pattern on the second active pattern;
   a lower isolation insulating layer between the first and second active patterns; and
   a gate electrode extending in the first direction,
   wherein the first and third source/drain patterns are arranged in the first direction,
   the second and fourth source/drain patterns are arranged in the first direction,
   a maximum width of the first source/drain pattern in the first direction is greater than a maximum width of the second source/drain pattern in the first direction,
   a maximum width of the third source/drain pattern in the first direction is greater than a maximum width of the fourth source/drain pattern in the first direction, and
   a first sidewall of the first source/drain pattern and a first sidewall of the third source/drain pattern are in contact with the lower isolation insulating layer.
Clause 10. The semiconductor device of Clause 9, further comprising a first upper isolation insulating layer on the lower isolation insulating layer,
   wherein a second sidewall of the first source/drain pattern and a second sidewall of the third source/drain pattern are in contact with the first upper isolation insulating layer.
Clause 11. The semiconductor device of Clause 10, wherein the first source/drain pattern comprises a surface connecting the first sidewall and the second sidewall of the first source/drain pattern,
   the third source/drain pattern comprises a surface connecting the first sidewall and the second sidewall of the third source/drain pattern, and
   the surface of the first source/drain pattern and the surface of the third source/drain pattern are in contact with the lower isolation insulating layer.
Clause 12. The semiconductor device of Clause 10 or Clause 11, further comprising a second upper isolation insulating layer between the second and fourth source/drain patterns,
   wherein the second and fourth source/drain patterns are spaced apart from the second upper isolation insulating layer.
Clause 13. The semiconductor device of Clause 12, wherein a lower surface of the second upper isolation insulating layer has a lower level than a lower surface of the first upper isolation insulating layer.
Clause 14. The semiconductor device of Clause 12 or Clause 13, wherein the second upper isolation insulating layer has a greater height than the first upper isolation insulating layer.
Clause 15. The semiconductor device of any of Clauses 10-14, further comprising a first upper source/drain pattern and a second upper source/drain pattern in contact with sidewalls of the first upper isolation insulating layer,
   wherein the first upper source/drain pattern overlaps the first source/drain pattern, and
   the second upper source/drain pattern overlaps the third source/drain pattern.
Clause 16. The semiconductor device of any of Clauses 10-15, wherein a width of the first upper isolation insulating layer in the first direction is smaller than a width of the lower isolation insulating layer in the first direction.
Clause 17. The semiconductor device of any of Clauses 9-16, further comprising:
   a first semiconductor pattern in contact with the first source/drain pattern;
   a second semiconductor pattern in contact with the second source/drain pattern; and
   a third semiconductor pattern between the first and second semiconductor patterns,
   wherein the third semiconductor pattern includes:
      a first part adjacent to the first semiconductor pattern; and
      a second part adjacent to the second semiconductor pattern, and
   a width of the first part of the third semiconductor pattern in the first direction is greater than a width of the second part of the third semiconductor pattern in the first direction.
Clause 18. The semiconductor device of Clause 17, wherein a width of the first semiconductor pattern in the first direction is greater than a width of the second semiconductor pattern in the first direction.
Clause 19. A semiconductor device comprising:
   a first active pattern and a second active pattern spaced apart from each other in a first direction;
   a first source/drain pattern and a second source/drain pattern on the first active pattern;
   a third source/drain pattern and a fourth source/drain pattern on the second active pattern;
   a first semiconductor pattern in contact with the first source/drain pattern;
   a second semiconductor pattern in contact with the second source/drain pattern;
   a third semiconductor pattern in contact with the third source/drain pattern;
   a fourth semiconductor pattern in contact with the fourth source/drain pattern;
   a lower isolation insulating layer between the first and second active patterns, between the first and third source/drain patterns, and between the first and third semiconductor patterns;
   a first upper isolation insulating layer between the first and third source/drain patterns;
   a second upper isolation insulating layer between the second and fourth source/drain patterns; and
   a gate electrode extending in the first direction,
   wherein a width of the first source/drain pattern in the first direction is greater than a width of the second source/drain pattern in the first direction, and
   a width of the first semiconductor pattern in the first direction is greater than a width of the second semiconductor pattern in the first direction.
Clause 20. The semiconductor device of Clause 19, wherein the first upper isolation insulating layer is in contact with the first and third source/drain patterns, and
   the second upper isolation insulating layer is spaced apart from the second and fourth source/drain patterns.

Although the embodiments of the present invention have been described, it is understood that the present invention should not be limited to these embodiments but various changes and modifications can be made by one ordinary skilled in the art within the spirit of the present invention as hereinafter claimed.

## Claims

1. A semiconductor device comprising:
a first active pattern and a second active pattern spaced apart from each other in a first direction;
a first semiconductor pattern and a second semiconductor pattern overlapping the first active pattern;
a third semiconductor pattern and a fourth semiconductor pattern overlapping the second active pattern;
a lower isolation insulating layer between the first and second active patterns;
source/drain patterns on the first and second active patterns; and
a gate electrode extending in the first direction,
wherein the first and third semiconductor patterns are arranged in the first direction,
the second and fourth semiconductor patterns are arranged in the first direction,
a width of the first semiconductor pattern in the first direction is greater than a width of the second semiconductor pattern in the first direction,
a width of the third semiconductor pattern in the first direction is greater than a width of the fourth semiconductor pattern in the first direction, and
a sidewall of the first semiconductor pattern and a sidewall of the third semiconductor pattern are in contact with the lower isolation insulating layer.

2. The semiconductor device of claim 1, wherein a minimum width of the first semiconductor pattern in the first direction is greater than a minimum width of the second semiconductor in the first direction, and
a minimum width of the third semiconductor pattern in the first direction is greater than a minimum width of the fourth semiconductor in the first direction.

3. The semiconductor device of claim 1 or claim 2, wherein the lower isolation insulating layer comprises:
a first isolation part between the first and third semiconductor patterns; and
a second isolation part between the second and fourth semiconductor patterns, and
a width of the first isolation part in the first direction is smaller than a width of the second isolation part in the first direction.

4. The semiconductor device of claim 3, wherein the sidewall of the first semiconductor pattern and the sidewall of the third semiconductor pattern are in contact with the first isolation part, and
a sidewall of the second semiconductor pattern and a sidewall of the fourth semiconductor pattern are in contact with the second isolation part.

5. The semiconductor device of claim 3 or claim 4, wherein the first isolation part comprises a lower portion and an upper portion,
the second isolation part comprises a lower portion and an upper portion,
the source/drain patterns comprise:
a first source/drain pattern and a second source/drain pattern in contact with an upper surface of the lower portion of the first isolation part; and
a third source/drain pattern and a fourth source/drain pattern in contact with an upper surface of the lower portion of the second isolation part, and
a maximum width of each of the first and second source/drain patterns in the first direction is greater than a maximum width of each of the third and fourth source/drain patterns in the first direction.

6. The semiconductor device of claim 5, further comprising:
a first upper isolation insulating layer on the lower portion of the first isolation part; and
a second upper isolation insulating layer on the lower portion of the second isolation part,
wherein the first and second source/drain patterns are in contact with the first upper isolation insulating layer, and
the third and fourth source/drain patterns are in contact with the second upper isolation insulating layer.

7. The semiconductor device of any of claims 1-4, wherein the source/drain patterns comprise:
a first source/drain pattern and a second source/drain pattern on the first active pattern; and
a third source/drain pattern and a fourth source/drain pattern on the first active pattern,
a maximum width of the first source/drain pattern in the first direction is greater than a maximum width of the second source/drain pattern in the first direction,
a maximum width of the third source/drain pattern in the first direction is greater than a maximum width of the fourth source/drain pattern in the first direction, and
a first sidewall of the first source/drain pattern and a first sidewall of the third source/drain pattern are in contact with the lower isolation insulating layer.

8. The semiconductor device of claim 7, further comprising a first upper isolation insulating layer on the lower isolation insulating layer,
wherein a second sidewall of the first source/drain pattern and a second sidewall of the third source/drain pattern are in contact with the first upper isolation insulating layer.

9. The semiconductor device of claim 8, wherein the first source/drain pattern comprises a surface connecting the first sidewall and the second sidewall of the first source/drain pattern,
the third source/drain pattern comprises a surface connecting the first sidewall and the second sidewall of the third source/drain pattern, and
the surface of the first source/drain pattern and the surface of the third source/drain pattern are in contact with the lower isolation insulating layer.

10. The semiconductor device of claim 8 or claim 9, further comprising a second upper isolation insulating layer between the second and fourth source/drain patterns,
wherein the second and fourth source/drain patterns are spaced apart from the second upper isolation insulating layer.

11. The semiconductor device of claim 10, wherein a lower surface of the second upper isolation insulating layer has a lower level than a lower surface of the first upper isolation insulating layer.

12. The semiconductor device of claim 10 or claim 11, wherein the second upper isolation insulating layer has a greater height than the first upper isolation insulating layer.

13. The semiconductor device of any of claims 8-12, further comprising a first upper source/drain pattern and a second upper source/drain pattern in contact with sidewalls of the first upper isolation insulating layer,
wherein the first upper source/drain pattern overlaps the first source/drain pattern, and
the second upper source/drain pattern overlaps the third source/drain pattern.

14. The semiconductor device of any preceding claim, wherein the second and fourth semiconductor patterns are spaced apart from the lower isolation insulating layer.

15. The semiconductor device of any of claims 1-13, wherein a sidewall of the second semiconductor pattern and a sidewall of the fourth semiconductor pattern are in contact with the lower isolation insulating layer.
